# EUROPÄISCHE PATENTSCHRIFT

(11) **EP 2 906 403 B1**
(45) Veröffentlichungstag und Bekanntmachung des Hinweises auf die Patenterteilung: **08.04.2020**
(21) Anmeldenummer: 13777032.7
(22) Anmeldetag: 14.10.2013
(51) Int. Cl.: B29C 45/14, G06F 3/045

(54) **DURCH IN-MOULD-VERFAHREN HERGESTELLTER KÖRPER UND VERFAHREN ZU SEINER HERSTELLUNG**
BODY PRODUCED BY AN IN-MOULD PROCESS AND PROCESS FOR THE PRODUCTION THEREOF
CORPS FABRIQUÉ PAR UN PROCÉDÉ DE FINITION DANS LE MOULE ET PROCÉDÉ POUR LE FABRIQUER

(30) Priorität: 15.10.2012 DE 102012109820
(43) Veröffentlichungstag der Anmeldung: 19.08.2015
(73) Patentinhaber: Leonhard Kurz Stiftung & Co. KG, 90763 Fürth (DE); PolyIC GmbH & Co. KG, 90763 Fürth (DE)
(72) Erfinder: HAHN, Martin, 91567 Herrieden (DE); CLEMENS, Wolfgang, 90617 Puschendorf (DE); SIGRITZ, Rainer, 90419 Nürnberg (DE); SCHINDLER, Ulrich, 90518 Altdorf (DE); GOLLING, Gerald, 90552 Oberasbach (DE)
(74) Vertreter: Louis Pöhlau Lohrentz
(86) Internationale Anmeldenummer: PCT/EP2013/071388
(87) Internationale Veröffentlichungsnummer: WO 2014/060335

(56) Entgegenhaltungen:
- EP-A1- 2 695 715
- JP-A- 2009 238 661
- JP-A- 2011 240 679
- JP-A- 2012 011 691

## Beschreibung

Die Erfindung betrifft einen Körper, nämlich ein Kunststoffteil, das insbesondere durch ein In-Mould-Verfahren hergestellt ist. Sie betrifft auch ein Verfahren zur Herstellung eines solchen Körpers.

Bei einem In-Mould-Verfahren unterscheidet man zwischen dem In-Mould-Labeling (IML) und dem In-Mould-Dekorieren (IMD). Beim In-Mould-Verfahren wird vorliegend insbesondere eine erste Folie hinterspritzt. Beim In-Mould-Labeling wird die gesamte erste Folie Teil des fertigen Körpers bzw. Kunststoffteils. Bei der In-Mould-Dekoration verwendet man ein Rolle-zu-Rolle-Verfahren, bei dem ein Folienband durch die Spritzgussform hindurchgeführt wird. Das Folienband weist eine Trägerschicht und eine Übertragungslage auf. Die Übertragungslage kann sich von der Trägerschicht lösen. Insbesondere nach dem Hinterspritzen verbleibt die Übertragungslage an dem fertigen Körper, wohingegen die Trägerschicht abgelöst wird und weitertransportiert wird.

Es ist bekannt, die Technik des In-Mould-Labelings im Zusammenhang mit einer ersten Folie einzusetzen, die zumindest eine elektrische oder elektronische Funktionsschicht aufweist. In einem Funktionsbereich der Funktionsschicht ist zumindest ein elektrisches und/oder elektronisches Bauelement bereitgestellt; in einem Kontaktierungsbereich der zumindest einen Funktionsschicht ist zumindest ein elektrischer Anschluss vorgesehen, der galvanisch mit zumindest einem Bauelement gekoppelt ist, nämlich in der Funktionsschicht galvanisch gekoppelt ist, über Verbindungen in derselben.

Nun ist es nachteilig, wenn der Kontaktierungsbereich ebenfalls hinterspritzt ist, denn dann haftet er an dem Spritzgussmaterial und kann nicht zu einem Gegenkontakt geführt werden.

Die JP 2012 011 691 A beschreibt einen Spritzgussartikel mit integriertem leitendem Schaltkreis. Der Spritzgussartikel weist einen aus Harz gegossenen Körper und eine Basisfolie auf, wobei die Basisfolie im Körper eingebettet ist und mit einer Oberfläche des Körpers bündig abschließt. Der Spritzgussartikel weist zudem eine Leitung auf, wobei ein Ende der Leitung im Spritzgussartikel eingebettet ist und mit dem leitenden Schaltkreis verbunden ist und das andere Ende der Leitung aus dem Artikel herausragt.

In der JP 2011 240 679 A wird ein Verfahren zum Spritzgießen beschrieben, bei dem ein metallische Gitterschicht auf einem Träger angeordnet wird ("metallic mesh sheet". Auf die metallische Gitterschicht wird ein wärmebeständiges Band eingelegt, bevor ein Hinterspritzen erfolgt.

Aus der EP 2 695 715 A1 ist beispielsweise ein Gerätemodul mit einer Basis aus einem Kunststoffmaterial, einem Kunststoffelement, einem Sensor und einer flexiblen externen Verbindung bekannt, wobei die Verbindung mit dem Sensor verbunden ist und ein Teil der Verbindung im Kunststoffelement angeordnet ist.

Es ist die Aufgabe der Erfindung, einen Weg aufzuzeigen, wie ein Körper, der als Kunststoffteil durch ein In-Mould-Verfahren hergestellt ist, ausgestaltet werden kann, damit er optimal in elektrischen oder elektronischen Geräten eingesetzt werden kann, ohne dass ein Problem mit der Kontaktierung besteht. Zur Aufgabe gehört auch die Angabe eines Weges zur Herstellung eines solchen Körpers.

Die Aufgabe wird durch einen Körper gelöst, der eine erste Folie mit zumindest einer elektrischen und/oder elektronischen Funktionsschicht auf einem Substrat aus Kunststoff aufweist, wobei in einem Funktionsbereich der Funktionsschicht zumindest ein elektrisches und/oder elektronisches Bauelement bereitgestellt ist, und wobei in einem Kontaktierungsbereich der zumindest einen Funktionsschicht zumindest ein elektrischer Anschluss vorgesehen ist, der (insbesondere über Verbindungen in der Funktionsschicht) galvanisch mit zumindest einem Bauelement gekoppelt ist, wobei der Körper ferner ein Kunststoffhauptmaterial umfasst, wobei sich die Hafteigenschaften zwischen der ersten Folie und dem Kunststoffhauptmaterial in einem ersten Bereich von denjenigen in einem zweiten Bereich unterscheiden und die erste Folie mit dem Kunststoffhauptmaterial partiell so hinterspritzt ist, dass der Kontaktierungsbereich zumindest teilweise von Kunststoffhauptmaterial frei ist, wobei die erste Folie derart ausgebildet ist, dass durch einen nicht hinterspritzten Teil der ersten Folie ein von dem Kunststoffhauptmaterial getrenntes Fähnchen bereitgestellt ist, welches sich an einen hinterspritzten Teil der ersten Folie in einem Oberflächenbereich des Körpers anschließt, der von einem die Oberfläche mit der ersten Folie begrenzenden Rand des Körpers beabstandet ist.

Die vorliegende Erfindung beinhaltet zwei Ideen: Zum Einen wird der Kontaktierungsbereich zumindest teilweise nicht hinterspritzt und kann daher wie ein Fähnchen von dem restlichen Körper, insbesondere der Oberfläche des Kunststoffhauptmaterials, wegstehen; er kann insbesondere so wegstehen, dass er zu einem Gegenkontakt geführt werden kann, wo der zumindest eine elektrische Anschluss tatsächlich angeschlossen werden kann. Die zweite Idee beinhaltet, dass das nicht hinterspritzte Teil in Form des Fähnchens gerade nicht am Rand des Körpers vorgesehen ist, wie es herstellungstechnisch besonders einfach zu realisieren wäre; sondern das Fähnchen steht von einem Oberflächenbereich des Körpers weg, der sich inmitten des Körpers befindet. Man kann das Fähnchen also so anstellen, dass die zur Oberfläche des restlichen Körpers weisende Seite des Fähnchens zu einem Bereich mit Kunststoffhauptmaterial hinweist. Es ist daher jenseits des Oberflächenbereichs, in dem der hinterspritzte Bereich der ersten Folie in den nicht hinterspritzten Teil der ersten Folie übergeht, noch weiter Kunststoffhauptmaterial vorhanden. Auf diese Weise kann der Körper mit seinem Randbereich an andere Elemente eines elektrischen Gerätes angesetzt oder in diese eingesetzt werden, ohne dass die Möglichkeit der Kontaktierung an dem zumindest einen elektrischen Anschluss verloren geht. Das Fähnchen mit dem zumindest einen elektrischen Anschluss ragt beispielsweise ins Innere eines Gehäuses, das von dem Körper begrenzt wird, und wobei der Rand des Körpers an anderen Gehäuseteilen ansitzt.

Es kann insbesondere das Merkmal eines flexiblen Fähnchens verwirklicht sein, und die obige Beschreibung führt dann zu dem Merkmal, dass durch das Kunststoffhauptmaterial eine Körperform vorgegeben ist, die es erlaubt, das Fähnchen zumindest partiell in Anlage an die Oberfläche des Kunststoffhauptmaterials auf dessen Seite mit der ersten Folie zu bringen. Mit anderen Worten ist der hinterspritzte Teil der ersten Folie einstückig mit dem Kunststoffhauptmaterial, dann setzt sich aber die Folie gewissermaßen über dem Kunststoffhauptmaterial fort, bleibt aber in diesem Bereich von dem Kunststoffhauptmaterial getrennt.

Bei einer Ausführungsform ist es vorgesehen, dass der Körper eine ebene Oberfläche aufweist, an der die erste Folie angeordnet ist. Das Fähnchen ist in eine Lage verbringbar oder in einer Lage befindlich, in der es einem Winkel aus dem Intervall von 15° - 90° zur Ebene von einem Oberflächenbereich weg steht, an den sich bezüglich der Oberfläche allseitig Kunststoffhauptmaterial anschließt. Ein solcher ebener Körper lässt sich in Form einer Platte besonders leicht in ein elektrisches Gerät integrieren, wobei die Platte z. B. eine Gehäuseseite bereitstellen kann. Das wegstehende Fähnchen erstreckt sich beispielsweise zu einem im Inneren des Gehäuses vorgesehenen Gegenkontakt.

Bei einer anderen Ausführungsform weist der Körper eine gekrümmte Oberfläche auf, an der die erste Folie angeordnet ist. Das Fähnchen ist in eine Lage verbringbar oder in einer Lage befindlich, in der es in einem Winkel aus dem Intervall von 75° - 0° zu einer Flächennormalen der gekrümmten Oberfläche weg steht, wobei die Flächennormale zu einem Oberflächenbereich bzw. einem Oberflächenpunkt definiert ist, an den sich bezüglich der Oberfläche allseitig Kunststoffhauptmaterial anschließt. Der Winkel von 75° - 0° zur Flächennormalen entspricht einem Winkel von 15° - 90° zur Tangentenebene, die an einem solchen Oberflächenbereich definiert ist. Die Erfindung ist also auch im Zusammenhang mit einer dreidimensional ausgestellten Oberfläche verwirklichbar, an der die erste Folie mit der Funktionsschicht angeordnet ist. Auch hier ist es vorteilhaft, dass ein nicht hinterspritztes und daher insbesondere flexibles Fähnchen bereitgestellt ist, das das Anschließen eines Gegenkontaktes auf besonders leichte Weise ermöglicht.

Der Abstand des Übergangsbereichs zwischen dem hinterspritzten Teil und dem nicht hinterspritzten Teil der ersten Folie von einem Rand der Folie lässt sich durch folgende Beziehung genauer angeben: man definiert den Übergangsbereich als Linie auf der Oberfläche des Körpers und zu dem Rand eine Randkontur. Dann ist bevorzugt vorgesehen, dass ein Übergang von einem hinterspritzten Teil der Folie zu einem nicht hinterspritzten Teil der Folie längs einer Linie auf der Oberfläche erfolgt, welche zumindest 2mm, bevorzugt zumindest 3mm, besonders bevorzugt zumindest 5mm, ganz bevorzugt zumindest 8mm von einer die Oberfläche mit der Folie begrenzenden Randkontur des Körpers entfernt ist. Die Angabe der Entfernung bezieht sich auf die Mindestentfernung, insbesondere muss die Linie nicht parallel zur Randkontur verlaufen.

Bei einer bevorzugten Ausführungsform der Erfindung weist der Körper eine zweite Folie auf, die ebenfalls mit dem Kunststoffhauptmaterial hinterspritzt ist und eine Dekorschicht aufweist. In der Regel wird man diese zweite Folie auf einer der Seite mit der ersten Folie entgegengesetzten Seite des Körpers vorsehen. Ist der Körper insgesamt transparent, kann die Dekorschicht dafür sorgen, dass man von außen die erste Folie bzw. deren einzelne Schichten, darunter die elektrische oder elektronische Funktionsschicht, nicht erkennt. Besonders bevorzugt ist es, wenn die Dekorschicht zumindest eine Information hinsichtlich des zumindest einen elektrischen und/oder elektronischen Bauelements bereitstellt. Dies kann insbesondere nach Art einer Bedienhilfe erfolgen.

Diese Ausführungsform ist in besonderem Maße sinnvoll in Zusammenhang mit einer Tastfeldfunktionalität. Ganz allgemein kann der Körper eine Funktionsschicht mit kapazitiven Bauelementen umfassen, die eine solche Tastfeldfunktionalität bereitstellen. Solche Kunststoffteile sind in vielen Arten von elektrischen Geräten sinnvoll einsetzbar, z. B. in Mobilfunktelefonen, in elektrischen Hausgeräten ("Weiße Ware") oder auch in und an Automobilen. Insbesondere im Zusammenhang mit der die Information bereitstellenden Dekorschicht kann die Bedienung derartiger Geräte erleichtert sein, durch die Dekorschicht kann angezeigt werden, was und gegebenenfalls wie es zu berühren ist, um einen bestimmten Effekt zu erzielen.

Bei einer bevorzugten Ausführungsform des Körpers ist an dem Fähnchen ein Versteifungselement vorgesehen, das beispielsweise ein sicheres Anschließen des Kontaktbereichs des Fähnchens an einen Gegenkontakt ermöglicht. Das Versteifungselement kann aus Polyehtylenterepthalat, Polypropylen, Polycarbonat oder Polyethylennaphthalat bestehen und hierbei eine solche Foliendicke aufweisen, dass die Gesamtdicke aus der übrigen Folie mit dem Versteifungselement im Bereich von 150 - 600 µm liegt, z. B. etwa 300 µm beträgt. Alternativ oder zusätzlich kann ein weiteres Kontaktelement vorgesehen sein, das die Kontaktierung erleichtert. Das weitere Kontaktelement kann eine Dicke aus dem Intervall von 1 - 15 µm aufweisen, vorzugsweise 2 -5 µm, und aus Carbon Black oder Leitsilber bestehen.

Als Kunststoffhauptmaterial, das spritzgegossen wird, eignet sich prinzipiell jeder thermoplastische Kunststoff, wobei bevorzugt Polymethyl(meth)Acrylat, Acryl-Nitril-Butadien-Styrol, Polycarbonat oder Polyamid vorgesehen sind.

Ein solches Kunststoffmaterial kann gefärbt sein, damit man nicht in das Innere eines Gehäuses blicken kann, das von dem Körper begrenzt ist. Bei einer anderen bevorzugten Variante ist hingegen das Kunststoffhauptmaterial transparent und ermöglicht somit ein Hindurchschauen durch den Körper. Dies gilt in besonderem Maße dann, wenn auch die elektrische bzw. elektronische Funktionsschicht in der ersten Folie des Körpers transparent wirkt. Diese Maßnahme ist beispielsweise dadurch erzielbar, dass die elektrische bzw. elektronische Funktionsschicht eine Vielzahl von leitfähigen Bahnen (Leiterbahnen) aufweist, die aus Metall, insbesondere aus Silber, Kupfer, Aluminium, Chrom, oder aus einer Metalllegierung bestehen, und die eine Breite von zwischen 1 µm und 40 µm aufweisen (bevorzugt zwischen 5 µm und 25 µm), und die gleichzeitig einen Abstand von 10 µm bis 5mm zueinander haben (bevorzugt liegt er zwischen 300 µm und 1 mm). Solche Leiterbahnen sind für das menschliche Auge nicht bzw. schwer auflösbar und können daher nicht einzeln erkannt werden. Die Transparenz der elektrischen Funktionsschicht beträgt mindestens 70 % und bevorzugt mindestens 80 % trotz der metallischen Leiterbahnen. Diese Leiterbahnen sind bevorzugt in einer Schichtdicke aus dem Intervall von 10 - 150 nm, bevorzugt aus dem Intervall von 30 - 60 nm, bereitgestellt.

Die elektrische bzw. elektronische Funktionsschicht kann auch solche leitfähigen Bahnen aus Metall, insbesondere den genannten Materialien, umfassen, die mindestens 100 µm breit sind. Solche Bahnen sind an sich gut sichtbar, sie können aber durch ein Kunststoffmaterial, etwa in einer gesonderten Dekorlage oder durch das Substrat, verdeckt werden.

In einer anderen Ausführungsform weist die elektrische Funktionsschicht organische Leiter wie PAni (Polyanilin) oder PEDOT/PSS (Poly-3,4-ethylendioxythiophen/Polystyrolsulfonat) auf. Außerdem kann die elektrische bzw. elektronische Funktionsschicht Metall-Nanodrähte (z. B. aus Silber, Kupfer oder Gold) oder Metall-Nanopartikeln (ebenfalls z. B. Silber, Kupfer oder Gold), oder Kohlenstoff-Nanoröhrchen oder Kohlenstoff-Nanopartikeln oder Graphen umfassen.

Ferner können Kombinationen der genannten Materialien in der Funktionsschicht vorgesehen sein.

Das Substrat besteht insbesondere aus Polyethylenterephthalat, Polypropylen, Polycarbonat und/oder Polyethylennaphthalat, vorzugsweise in einer Dicke aus dem Intervall von 12 - 150 µm, besonders bevorzugt aus dem Intervall von 35 - 60 µm.

Um die weiteren Schichten bei dem Hinterspritzen vor der hohen Temperatur des Spritzgussmaterials (des Kunststoffhauptmaterials) zu schützen, kann das Substrat zwischen der Funktionsschicht und dem Kunststoffhauptmaterial angeordnet sein.

Es kann aber auch vorteilhaft sein, wenn die Funktionsschicht zwischen dem Substrat und dem Kunststoffhauptmaterial angeordnet ist; dann dient nämlich das Substrat an dem fertigen Körper selbst als Schutz für die Funktionsschicht. Damit Spritzgussmaterial gut an einem Folienmaterial haftet, sieht man regelmäßig eine Haftvermittlerschicht vor. Entsprechend ist bevorzugt eine solche Haftvermittlerschicht zumindest an dem mit Kunststoff hinterspritzten Teil der ersten Folie vorgesehen. (An dem mit Kunststoff nicht hinterspritzten Teil der ersten Folie ist entweder keine Haftvermittlerschicht oder eine das Gegenteil, also die Unterdrückung der Haftung bewirkende Schicht, vorgesehen.) Die Haftvermittlerschicht kann aus einer einzigen Schicht bestehen, es gibt aber auch die Möglichkeit der Bereitstellung zweier unterschiedlicher Teilschichten aus unterschiedlichem Material als Haftvermittlerschicht.

Die Aufgabe wird auch durch die Bereitstellung eines elektrischen Gerätes gelöst, welches ein Gehäuse umfasst, in oder an das ein Körper der erfindungsgemäßen Art ein- bzw. angesetzt ist, wobei in dem Gehäuse ein elektrisches oder elektronisches Bauteil angeordnet ist, welches über das von dem Kunststoffhauptmaterial wegstehende Fähnchen mit der elektrischen bzw. elektronischen Funktionsschicht (nämlich insbesondere den ein oder mehreren Bauelementen in selbiger) galvanisch gekoppelt ist. Hier wird die Funktion des Fähnchens zur Herstellung eines Anschlusses explizit genutzt. Das elektrische Gerät kann ein Mobilfunktelefon (Handy, Smartphone) sein, aber auch ein Haushaltsgerät, wie eine Waschmaschine, Spülmaschine, ein Backofen oder ein Herd und dergleichen. Schließlich kann es auch ein Automobilzubehörteil sein, z. B. kann der Körper Teil der Mensch-Maschine-Schnittstelle in einem solchen Automobil werden bzw. sein. Das elektrische Gerät kann auch zur Haushaltselektronik gehören wie beispielsweise ein Fernseher, ein DVD-Spieler, Spielkonsolen und dergleichen. Das elektrische Gerät kann ferner ein medizinisches Gerät sein, etwa ein Handgerät wie ein Glukosemeter, aber auch ein Messgerät und sonstiges Untersuchungsgerät. Das elektrische Gerät kann auch ein Automatisierungsgerät sein.

Die Erfindung umfasst in einem Aspekt auch ein Verfahren zum Herstellen eines Körpers, wobei es sich um einen Körper der erfindungsgemäßen Art handelt. Es gibt zwei mögliche Verfahren, die beide die Aufgabe lösen.

In einem ersten Aspekt der Erfindung wird ein Verfahren zum Herstellen eines Körpers bereitgestellt, bei dem eine erste Folie in eine Spritzgussform eingelegt wird, wobei die erste Folie in einem ersten Bereich Hafteigenschaften bzgl. eines vorbestimmten Spritzgussmaterials aufweist, die qualitativ besser sind als die entsprechenden Hafteigenschaften in einem zweiten Bereich der ersten Folie - also kann das Spritzgussmaterial besser an dem ersten Bereich als an dem zweiten Bereich haften -, wobei der zweite Bereich die Form einer von dem ersten Bereich wegstehenden Zunge aufweist, wobei bei dem Verfahren in die Spritzgussform mit der ersten Folie das vorbestimmte Spritzgussmaterial eingespritzt wird, sodass die erste Folie partiell hinterspritzt wird und sodann der hergestellte Körper (naturgemäß nach einem Öffnen der Spritzgussform) entnommen wird, wobei die erste Folie so in die Spritzgussform eingelegt wird, dass aufgrund der Eigenschaften des ersten Bereichs und des zweiten Bereichs der ersten Folie wegen der unterschiedlichen Hafteigenschaften Spritzgussmaterial an der ersten Folie in dem ersten Bereich anhaftet, Spritzgussmaterial an der ersten Folie in dem zweiten Bereich aber schlecht oder nicht anhaftet. Wenn er schlecht anhaftet kann sich noch der Schritt des, insbesondere manuellen, Abziehens des zweiten Bereichs von dem Spritzgussmaterial anschließen, sodass das oben bereits genannte Fähnchen entsteht.

Bei einer bevorzugten Ausführungsform wird eine Folie eingelegt, die eine Haftvermittlerschicht in dem ersten Bereich umfasst. Wegen der unterschiedlichen Hafteigenschaften zwischen dem ersten und dem zweiten Bereich heißt dies, dass in dem zweiten Bereich entweder keine Haftvermittlerschicht bereitgestellt ist oder eine Gegenmaßnahme getroffen ist. Diese Gegenmaßnahme kann auch unabhängig davon getroffen werden, ob eine Haftvermittlerschicht bereitgestellt wird. So ist es eine weitere bevorzugte Ausführungsform, dass eine Folie eingelegt wird, die eine die Haftung (an dem vorbestimmten Spritzgussmaterial) unterdrückende Schicht in dem zweiten Bereich umfasst.

In einem zweiten Aspekt der Erfindung wird ein Herstellungsverfahren für einen Körper bereitgestellt, wobei es sich um einen Körper der erfindungsgemäßen Art handelt, bei dem eine erste Folie in eine Spritzgussform eingelegt wird, wobei die erste Folie in einem ersten Bereich Hafteigenschaften bezüglich eines vorbestimmten Spritzgussmaterials aufweist, die qualitativ besser sind als die entsprechenden Hafteigenschaften in einem zweitem Bereich der ersten Folie, wobei der zweite Bereich die Form einer von dem ersten Bereich weg stehenden Zunge aufweist, und wobei bei dem Verfahren der zweite Bereich zwischen zwei Klemmteilen eingeklemmt wird und wobei Spritzgussmaterial in die Spritzgussform eingespritzt wird und so der erste Bereich der ersten Folie hinterspritzt wird (und insbesondere der zweite Bereich zumindest teilweise nicht hinterspritzt wird, weil die Klemmteile den zweiten Bereich von dem Spritzgussmaterial abtrennen bzw. -klemmen). Beim Einklemmen erfolgt ja eine Berührung von beiden Seiten, sodass Material nicht zwischen das Klemmteil und den zungenförmig wegstehenden zweiten Bereich der ersten Folie gelangen kann.

Bevorzugt ist hierbei vorgesehen, dass die Spritzgussform derart ausgebildet ist, dass beidseitig eines Übergangsbereichs von dem ersten Bereich zu dem zweiten Bereich der ersten Folie Spritzgussmaterial bereitgestellt wird. Dies bedeutet nichts anderes, als dass der nicht hinterspritzte zweite Bereich bzw. Teil des zweiten Bereichs ein Fähnchen bildet, das von einem Übergangsbereich weg steht, der von einer die Oberfläche mit der ersten Folie begrenzenden Rand des hergestellten Körpers entfernt ist. Beispielsweise erlaubt es sodann die Form des Körpers, das Fähnchen zumindest partiell in Anlage an die Oberfläche des Spritzgussmaterials auf dessen Seite mit der ersten Folie zu bringen.

Erfindungsgemäß lässt man als Klemmelemente die Formhälfte der Spritzgussform mit einem weiteren Element zusammenwirken, entweder einem gesonderten Schieber oder einem in der Formhälfte der Spritzgussform gelagerten Federauswerfer oder man sieht als Klemmelemente zwei durch einen Faltkern voneinander trennbare Klemmbacken vor, wobei diese Klemmbacken insbesondere an einer der beiden Formhälften angeordnet werden.

Neben einer in zwei Formhälften teilbaren Spritzgussform können diese beiden Ausführungsformen entsprechend auch bei Spritzgussformen mit mehr als zwei Formteilen verwirklicht werden. Die beiden Aspekte der Herstellung eines Körpers können auch in einem einzigen Verfahren verwirklicht sein. Naturgemäß müssen dann die angegebenen Schritte nicht jeweils zweifach durchgeführt werden. Beispielsweise würde der Schritt des Einlegens der ersten Folie und des Einbringens von Spritzgussmaterial in die Spritzgussform nur einmal vollzogen, wobei allerdings zugleich die unterschiedlichen Hafteigenschaften an der ersten Folie verwirklicht werden, als auch ein Einklemmen einer wegstehenden Zunge umgesetzt wird.

Bei einer bevorzugten Ausführungsform des erfindungsgemäßen Verfahrens wird eine zweite Folie in die Spritzgussform eingebracht, die ebenfalls hinterspritzt wird. Dies kann insbesondere eine In-Mould-Dekoration sein, es wird also eine Folie eingelegt, welche eine Trägerschicht und eine Übertragungslage umfasst und in einem Rolle-zu-Rolle-Verfahren zugeführt wird. Nach dem Hinterspritzen haftet die Übertragungslage zumindest partiell an dem Spritzgussmaterial an und wird von der Trägerschicht abgelöst. Die Trägerschicht wird im Rolle-zu-Rolle-Verfahren abgeführt.

Nachfolgend werden bevorzugte Ausführungsformen der Erfindung unter Bezug auf die Zeichnung näher beschrieben, in der:
- Fig. 1: eine schematische Schnittansicht durch ein Kunststoffteil als erfindungsgemäßen Körper gemäß einer ersten Ausführungsform der Erfindung veranschaulicht,
- Fig. 2: einen schematischen Schnitt durch ein elektronisches Gerät zeigt, in dem der Körper aus Fig. 1 eingesetzt ist,
- Fig. 3A/3B: in Draufsicht bzw. im Schnitt eine erste Herstellungsstufe eines bei dem erfindungsgemäßen Körper eingesetzten Folienelements gemäß einer ersten Ausführungsform zeigen,
- Fig. 4A/4B: in Draufsicht bzw. im Schnitt eine zweite Herstellungsstufe des bei dem erfindungsgemäßen Körper eingesetzten Folienelements zeigen,
- Fig. 5A/5B: in Draufsicht bzw. im Schnitt eine dritte Herstellungsstufe des bei dem erfindungsgemäßen Körper eingesetzten Folienelements zeigen,
- Fig. 6A/6B: in Draufsicht bzw. im Schnitt eine vierte Herstellungsstufe des bei dem erfindungsgemäßen Körper eingesetzten Folienelements zeigen,
- Fig. 7A/7B: in Draufsicht bzw. im Schnitt ein bei der Herstellung des erfindungsgemäßen Körpers eingesetztes Folienelement gemäß einer zweiten Ausführungsform in einer ersten Herstellungsstufe zeigen,
- Fig. 8A/8B: in Draufsicht bzw. im Schnitt das bei der Herstellung des erfindungsgemäßen Körpers eingesetzte Folienelement gemäß einer zweiten Ausführungsform in einer zweiten Herstellungsstufe zeigen,
- Fig. 9A/9B: in Draufsicht bzw. im Schnitt das bei der Herstellung des erfindungsgemäßen Körpers eingesetzte Folienelement gemäß einer zweiten Ausführungsform in einer dritten Herstellungsstufe zeigen,
- Fig. 10A/10B: in Draufsicht bzw. im Schnitt das bei der Herstellung des erfindungsgemäßen Körpers eingesetzte Folienelement gemäß einer zweiten Ausführungsform in einer vierten Herstellungsstufe zeigen,
- Fig. 11A/11B: in Draufsicht bzw. im Schnitt das bei der Herstellung des erfindungsgemäßen Körpers eingesetzte Folienelement gemäß einer zweiten Ausführungsform in einer fünften Herstellungsstufe zeigen,
- Fig. 12A: im Schnitt ein Folienelement nach Art des in Fig. 11B gezeigten Folieelements mit weiterer Schicht veranschaulicht,
- Fig. 12B: im Schnitt das Folienelement aus Fig. 12A nach einem Hinterspritzen veranschaulicht, wodurch ein Kunststoffteil hergestellt ist,
- Fig. 12C: das Kunststoffteil aus Fig. 12B nach einem partiellen Hochstellen eines Fähnchens veranschaulicht,
- Fig. 13A-13D: die bei einem Verfahren zur Herstellung eines Körpers gemäß einer ersten Alternative eingesetzten Komponenten in unterschiedlichen Herstellungsstufen veranschaulicht,
- Fig. 14A-14D: die bei einem Verfahren zur Herstellung eines Körpers gemäß einer zweiten Alternative eingesetzten Komponenten in unterschiedlichen Herstellungsstufen veranschaulicht,
- Fig. 15-17: unterschiedliche Schichtaufbauten für ein bei dem erfindungsgemäßen Körper einsetzbares Folienelement im schematischen Schnitt veranschaulichen,
- Fig. 18 und 19: Draufsichten auf unterschiedliche Ausführungsformen eines bei dem erfindungsgemäßen Körper einsetzbaren Folienelements sind,
- Fig. 20: eine Ansicht eines Folienelements gemäß Fig. 19 ist,
- Fig. 21A-21H: anhand schematisch gezeigter Bauteile eines Spritzgusswerkzeugs unterschiedliche Herstellungsstufen eines Verfahrens zur Herstellung eines erfindungsgemäßen Körpers gemäß einer dritten Alternative veranschaulicht,
- Fig. 22A-22H: anhand schematisch gezeigter Bauteile eines Spritzgusswerkzeugs unterschiedliche Herstellungsstufen eines Verfahrens zur Herstellung eines erfindungsgemäßen Körpers gemäß einer vierten Alternative veranschaulicht,
- Fig. 23A-23H: anhand schematisch gezeigter Bauteile eines Spritzgusswerkzeugs unterschiedliche Herstellungsstufen eines Verfahrens zur Herstellung eines erfindungsgemäßen Körpers gemäß einer fünften Alternative veranschaulicht,
- Fig. 24A-24H: anhand schematisch gezeigter Bauteile eines Spritzgusswerkzeugs unterschiedliche Herstellungsstufen eines Verfahrens zur Herstellung eines erfindungsgemäßen Körpers gemäß einer sechsten Alternative veranschaulicht,
- Fig. 25A/B: eine alternative Ausführungsform eines erfindungsgemäßen Körpers in perspektivischer Ansicht von oben bzw. von unten veranschaulichen und
- Fig. 26A/B: eine noch weitere alternative Ausführungsform eines erfindungsgemäßen Körpers in perspektivischer Ansicht von oben bzw. von unten veranschaulichen.

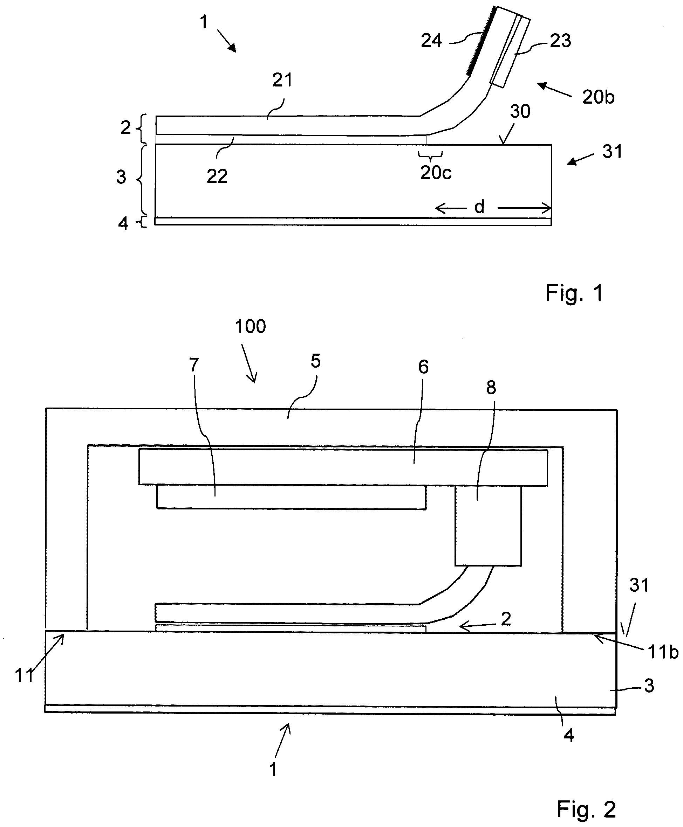

Ein in Fig. 1 gezeigter und im Ganzen mit 1 bezeichneter Körper umfasst eine erste Folie 2, Spritzgussmaterial 3 sowie eine zweite Folie 4 Die Schichtdicken der einzelnen Komponenten sind hierbei nicht maßstäblich gezeichnet. Die erste Folie 2 bildet ein Folienelement, das ein Substrat 21 umfasst, welches über eine Haftvermittlerschicht 22 (auch als "Primer" bezeichnet), an dem Spritzgussmaterial 3 anhaftet. Dieses Anhaften erfolgt jedoch lediglich in einem ersten Bereich 20a der ersten Folie 2, wohingegen ein zweiter Bereich 20b der ersten Folie nicht an der Oberfläche 30 des Spritzgussmaterials 3 anhaftet. Der Übergangsbereich 20c zwischen dem ersten und dem zweiten Bereich ist um mehrere Millimeter, beispielsweise 5 mm, von einer Randkontur 31 des Spritzgussmaterials 3 entfernt, siehe den in der Fig. 1 eingezeichneten Abstand d. Der zweite Bereich 20b der ersten Folie 2 trägt ein Verstärkungselement 23, das die Steifigkeit des Endes des zweiten Bereichs 20b erhöht. Außerdem ist eine Kontaktverstärkung 24 vorgesehen.

Vorliegend soll es sich bei der ersten Folie um eine solche Folie handeln, die eine elektrische Funktionsschicht trägt, beispielsweise in Form von kapazitiven Elementen zur Bereitstellung einer Tastfeldfunktionalität (sodass die Folie 2 eine Sensorfolie ist). Alternativ oder zusätzlich ist es möglich, dass die Folie 2 Leuchtdiodenelemente trägt, z. B. organische Leuchtdioden ("OLED"). Der zweite Bereich 20b, der ja vorliegend die Form eines von dem ersten Bereich 20a weg stehenden Fähnchens hat, kann insbesondere ein Kontaktierungsbereich sein, einen solchen Kontaktierungsbereich umfassen oder nur Teil eines Kontaktierungsbereichs sein; wesentlich ist, dass ein elektrischer Anschluss für die Elemente in der elektrischen Funktionsschicht im Bereich dieses Fähnchens, also im zweiten Bereich 20b vorgesehen ist, und die Kontaktverstärkung 24 hat die Funktion, ein Kontaktieren dieses Anschlusselements mit einem Gegenkontakt zu erleichtern.

Der Sinn des Wegstehens des Fähnchens ergibt sich aus der Anwendung des Körpers 1 in einem elektronischen Gerät 100, das in Fig. 2 gezeigt ist: Das elektronische Gerät umfasst ein Gehäuseteil 5, das aber kein geschlossenes Gehäuse bildet, sondern des Aufsetzens des Körpers 1 bedarf, um ein insgesamt geschlossenes Gehäuse bereitzustellen. Der Körper 1 sitzt insbesondere in einem Bereich 11a bzw. 11b an seinem jeweiligen Rand an dem Gehäuseteil 5 an. Dadurch, dass nun das Fähnchen von der Oberfläche 30 des Spritzgussmaterials 3 weg steht, kann die Folie 2 im Inneren des so gebildeten Gehäuses des elektronischen Geräts 100 kontaktiert werden. Die Kontaktierung erfolgt mit einer Elektronikplatine 6, welche ggf. Leuchtelemente oder ein Display 7 trägt, die den Körper 1 hinterleuchten können, über eine Steckverbindung 8. Insbesondere wird das mit dem Verstärkungselement 23 und der Kontaktverstärkung 24 versehene Ende des Fähnchens, also des zweiten Bereichs 20b, in die Steckverbindung 8 eingesteckt, sodass ein elektrischer Kontakt zwischen der Elektronikplatine 6 und den Bau- bzw. Funktionselementen in der ersten Folie 2 bereitgestellt ist.

Die zweiten Folie 4 kann ein vollständiges Label umfassen, das im Rahmen eines In-Mould-Labelings bereitgestellt wird. Bevorzugt handelt es sich bei der zweiten Folie 4 allerdings lediglich um die Übertragungslage einer Transferfolie, die beim Herstellungsverfahren von einer Trägerschicht abgelöst wurde. In diesem Fall lässt sich die zweite Folie 4 auch als Lackpaket bezeichnen.

Die zweite Folie 4 umfasst eine vollflächige oder partielle Dekorschicht oder Dekorlage, deren Funktion darin besteht, insbesondere neben der reinen Dekoration, eine Information hinsichtlich der ersten Folie 2 bzw. der darin enthaltenen Bauelemente bereitzustellen, sowie eine Schutzschicht gegen mechanische, physikalische und/oder chemische Einwirkungen auszubilden. Ist die erste Folie eine Folie mit Tastfeldfunktionalität, so können die einzelnen Tastfelder durch die Dekorlage angezeigt werden. Eine Bedienperson muss dann lediglich auf die symbolisch gezeigten Tastfelder tippen und aufgrund einer kapazitiven Wechselwirkung erfassen die kapazitiven Bauelemente in der ersten Folie 2 dieses Antippen im Zusammenwirken mit der Elektronikplatine 6. Alternativ kann die zweiten Folie 4 ausschließlich die Funktion einer Schutzschicht haben. Dies ist z. B. dann der Fall, wenn durch den Körper 1 ein Touchscreen bereitgestellt wird, etwa zum Einsatz in einem Smartphone; dann ist es wünschenswert, wenn die zweite Folie 4 transparent ist. Ein Display kann dann hinter dem Tastfeldsensor angeordnet sein und die Information zum Bedienen zeigen. Die Folie muss in diesem Fall nicht vollständig transparent sein, sondern kann im Displaybereich einen transparenten Bereich aufweisen und am Rand einen Rahmen.

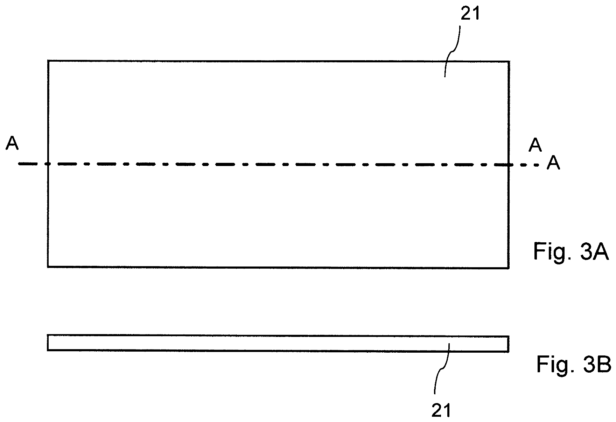

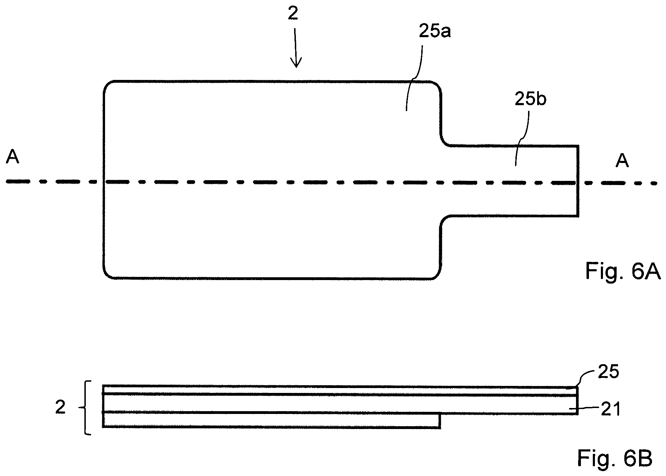

Es gibt nun unterschiedliche Möglichkeiten, wie ein Körper nach Art des Körpers 1 aus Fig. 1 hergestellt werden kann. Ein erstes Verfahren zur Herstellung eines solchen Körpers wird anhand der Fig. 3a/b bis 6a/b beschrieben:
Die jeweils mit "B" bezeichneten Figuren zeigen den Schnitt entlang der Linie "A-A" aus der jeweils zugehörigen mit "A" bezeichneten Figur.

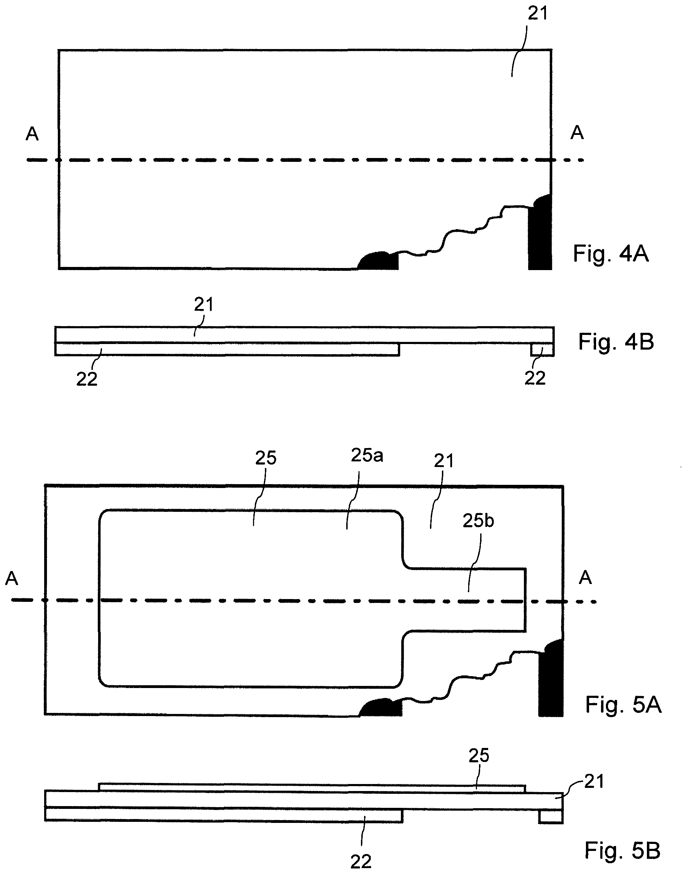

Zunächst wird das Substrat 21 bereitgestellt (Fig. 3A/B). Anschließend erfolgt eine partielle Beschichtung dieses Substrats 21 mit einer Haftvermittlerschicht 22, siehe die Fig. 4A/B. Sodann wird eine elektrische Funktionsschicht 25 auf das Substrat 21 auf der der Haftvermittlerschicht 22 abgewandten Seite aufgebracht, siehe Fig. 5A/B. Aus der Fig. 5A ist ersichtlich, dass die elektrische Funktionsschicht 25 nicht vollflächig aufgebracht wird, sondern einen ersten Bereich 25a umfasst, von dem ein zungenförmiger zweiter Bereich 25b weg steht. Die Zuordnung auf dem Substrat 21 ist der Gestalt, dass der zungeförmige Bereich 25b oberhalb des Bereichs des Substrats 21 liegt, der nicht mit der Haftvermittlerschicht 22 beschichtet ist.

Anschließend wird die erste Folie 2 zugeschnitten, wobei im Wesentlichen das gerade beschriebene Funktionselement ausgeschnitten wird. Man hat also auch hier den ersten Bereich 25a und den zweiten Bereich 25b und die entsprechende Zuordnung der Bereich in dem darunter liegenden Substrat 21.

Wird eine solche Folie 2 nun hinterspritzt, so kann man den Körper 1 aus Fig. 1 erhalten.

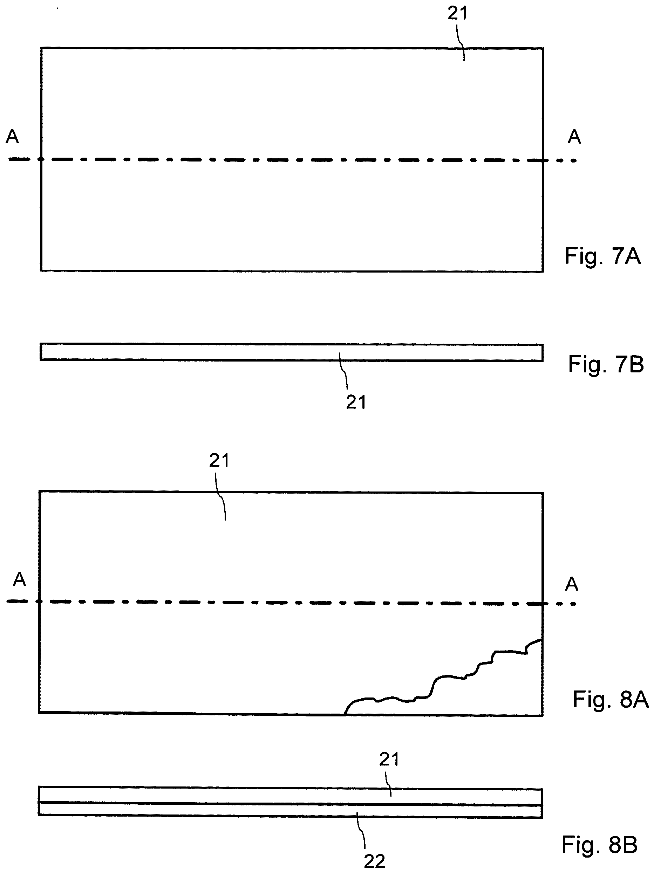

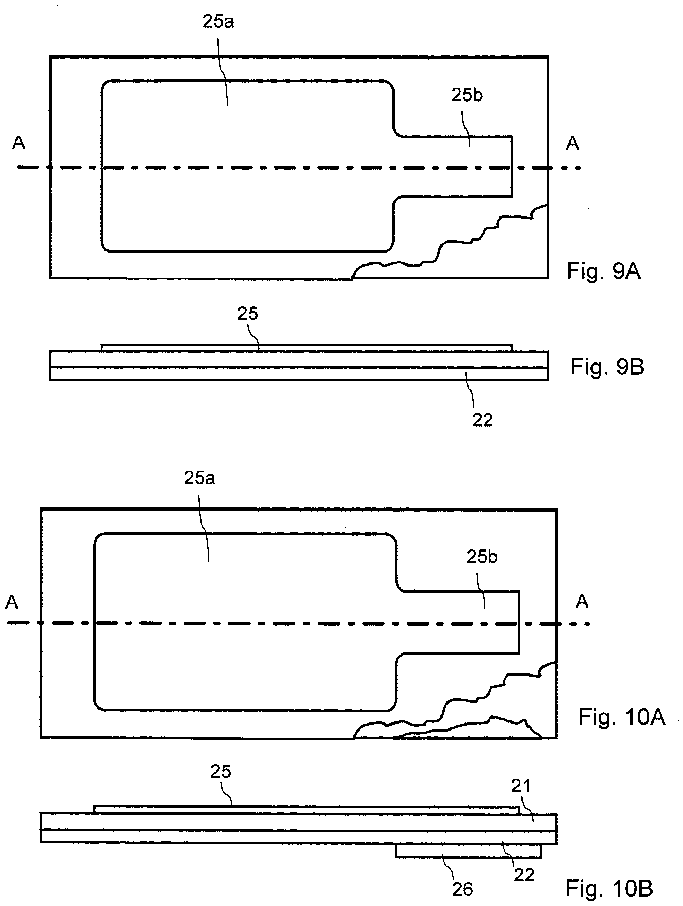

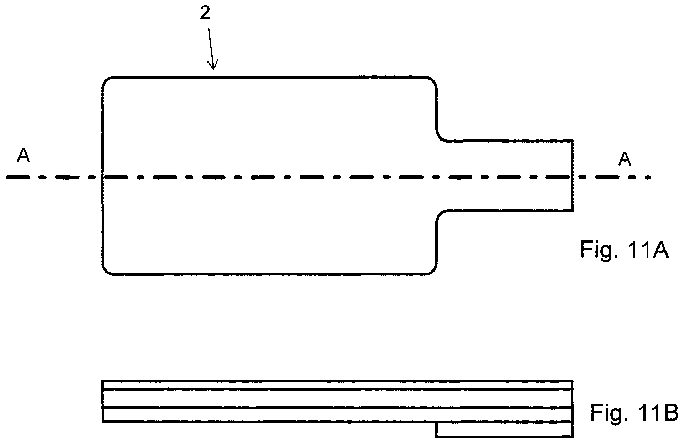

Bei einer zweiten Ausführungsform des Verfahrens wird zunächst auch wieder das Substrat 21 bereitgestellt, siehe Fig. 7A/B, dieses wird sodann aber vollflächig mit einer Haftvermittlerschicht 22 beschichtet, wie in den Fig. 8A/B zu sehen ist; die Fig. 8A stellt hierbei die Herstellungsstufe im teilweisen Aufriss dar. Auch hier wird anschließend, siehe Fig. 9A/B, eine elektrische Funktionsschicht 25 aufgebracht, die abermals einen ersten Bereich 25a und davon weg stehenden zungeförmigen Bereich 25b umfasst. Hier befindet sich jetzt auch unterhalb des zungeförmigen Bereichs 25b die Haftvermittlerschicht. Deren Wirkung wird aber durch eine die Haftung unterdrückende Zusatzschicht (Anti-Haft-Schicht) 26 unterbunden, nämlich genau in dem Bereich unterhalb des zungenförmigen Bereichs 25b der Funktionsschicht 25. Auch hier erfolgt wieder ein Ausstanzen oder Ausschneiden des Funktionselements zur Bereitstellung der ersten Folie 2, siehe Fig. 11A/B. Auch diese erste Folie 2 ist geeignet, bei der Herstellung des Körpers 1 aus Fig. 1 eingesetzt zu werden.

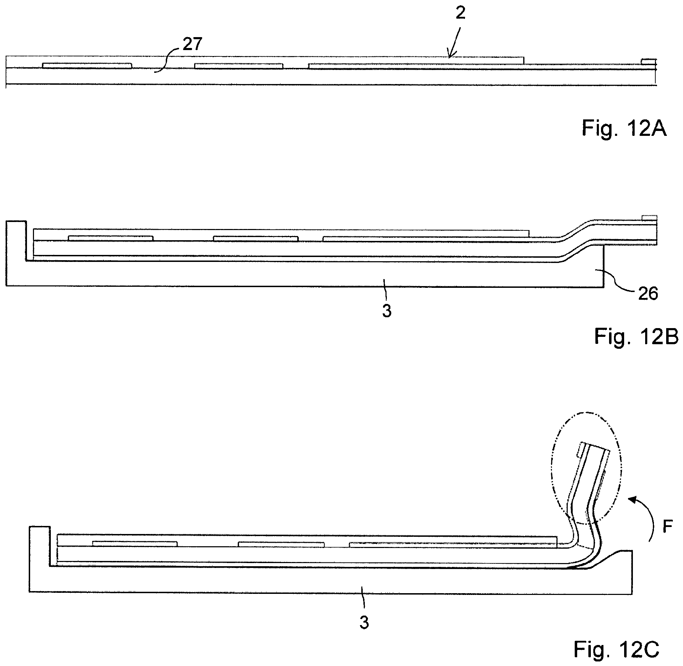

Die Fig. 12A - C veranschaulichen diese Situation mit der ersten Folie 2, die über die in Fig. 11b dargestellte Situation hinaus noch eine Zusatzschicht 27 als Schutzschicht für die elektrischen Funktionselemente in der Funktionsschicht 25 aufweist. Wird die Folie aus Fig. 12A hinterspritzt, erhält man die Situation gemäß Fig. 12B. Das Spritzgussmaterial 3 liegt insbesondere an der die Haftung unterdrückenden Schicht 26 ebenfalls an. In diesem Bereich lässt sich jedoch die Folie 2 von dem Spritzgussmaterial 3 abziehen, sodass die in Fig. 12C entstandene Situation entsteht, bei der ein Fähnchen F im Wesentlichen senkrecht von dem Spritzgussmaterial 3 weg steht. Wie eingangs unter Bezug auf Fig. 1 dargestellt, dient ein solches Fähnchen F im zweiten Bereich 20b der ersten Folie 2 zur in Fig. 2 dargestellten Kontaktierung in einem elektrischen oder elektronischen Gerät.

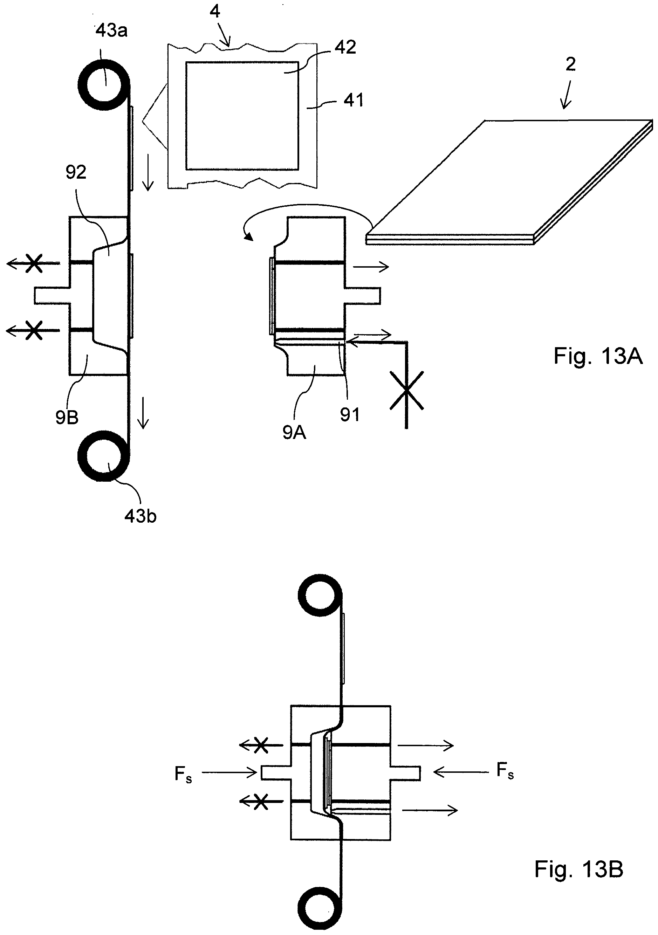

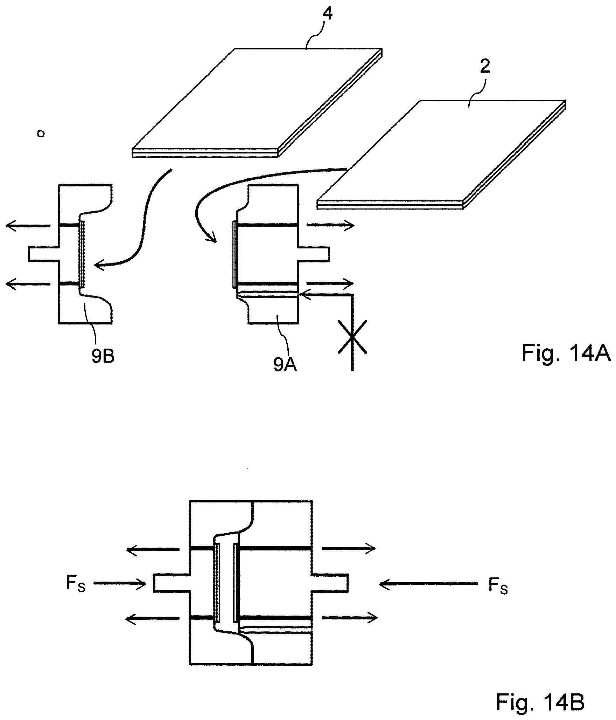

Es wurden unter Bezug auf die Fig. 3A/B bis 6A/B einerseits und 7A/B bis 11A/B zwei alternative Verfahren zur Herstellung eines Folienelements als erste Folie 2 dargestellt. Nachfolgend wird unter Bezug auf die Fig. 13A bis 13D ein erstes Verfahren erläutert, das jeweils einem Herstellungsverfahren für die erste Folie 2 folgt. Unter Bezug auf die Fig. 14A bis 14D wird ein zweites solches Verfahren erläutert, das alternativ diesen beiden Herstellungsverfahren für die erste Folie 2 folgt.

Eine in Fig. 13A gezeigte Spritzgussform umfasst vorliegend zwei Formhälften 9A und 9B. Vorliegend soll zugleich ein In-Mould-Labeling als auch ein In-Mould-Dekorieren in einem Schritt erfolgen. Das Label wird in Form der oben beschriebenen zweiten Folie 2 bereitgestellt. Diese wird auf die Spritzgussformhälfte 9A von Hand aufgelegt und mit Unterdruck beaufschlagt, sodass sie sich an die Formhälfte 9A anschmiegt. Die Pfeile in den Fig. 13A bis 13D sowie 14A bis 14D veranschaulichen hierbei die Wirkrichtung des Unterdrucks. Durchgestrichene Pfeile bedeuten, dass kein Unterdruck vorgesehen ist oder über eine Spritzgusszufuhrleitung 91 kein Spritzgussmaterial eingeführt wird. Im Bereich der zweiten Spritzgussform 9B, die eine Kavität 92 bereitstellt, wird die zweiten Folie 4 bereitgestellt, und zwar in Form einer Folienbahn, welche eine Trägerfolie 41 mit einer Dekorlage 42 umfasst. Die Dekorlage 42 wiederholt sich hierbei über den Verlauf der Trägerfolie. Die Folienbahn wird von einer ersten Rolle 43a abgerollt und später auf eine zweite Rolle 43b aufgerollt, die in der Figur nach unten weisenden Pfeile stehen hierbei für die Transportrichtung.

Nachdem die erste Folie 2 auf der ersten Formhälfte 9A platziert wurde und die zweite Folie 4 auf der zweiten Formhälfte 9B platziert wurde, letzteres ggf. unter Zuhilfenahme eines für Passergenauigkeit sorgenden (in der Figur nicht gezeigten) Sensors, wird eine Schließkraft F_{S} auf die beiden Formhälfte 9A/B ausgeübt. Nach wie vor wird die erste Folie 2 mit Unterdruck beaufschlagt, nicht aber wird die zweite Folie 4 mit Unterdruck beaufschlagt. Man erhält so die in Fig. 13B gezeigte Situation.

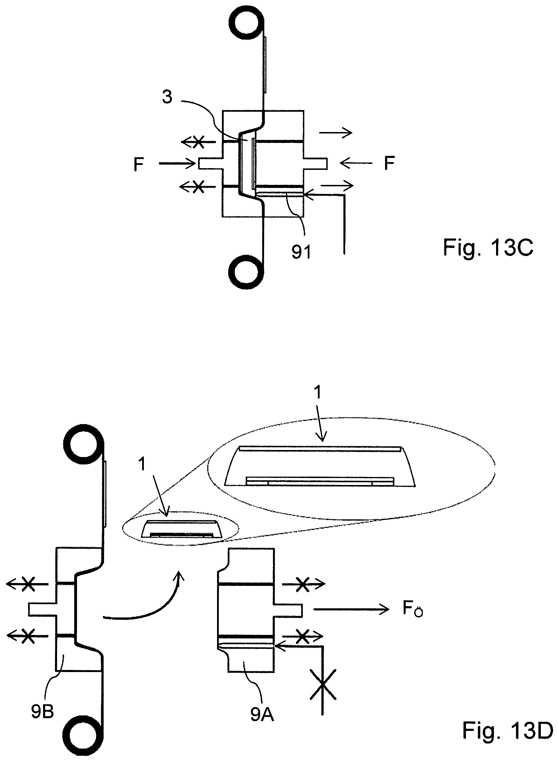

Weiter nachfolgend wird über eine Zufuhrleitung 91 Spritzgussmaterial 3 zwischen die erste Folie 2 und die zweite Folie 4 gespritzt, sodass beide Folien 2 und 4 hinterspritzt werden, siehe Fig. 13C. Nach einem Öffnen der beiden Spritzgussformhälften 9A/B unter Aufbringung der Öffnungskraft F_{Ö} erhält man den fertigen Körper 1; er ist in Fig. 13D im richtigen Maßstab im Verhältnis zu den Spritzgussformhälften 9A/B gezeigt, zugleich aber im vergrößerten Maßstab.

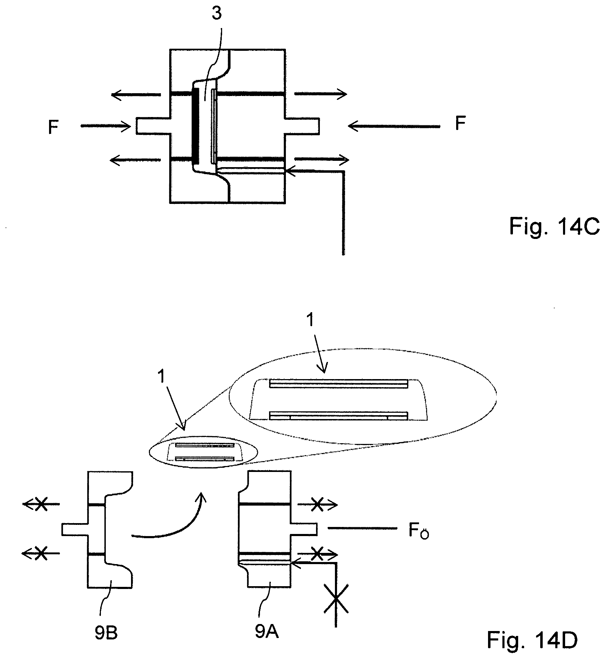

Bei dem alternativen Verfahren wird die Folie 2 abermals auf die erste Spritzgussform 9A gesetzt, gleichzeitig wird aber die zweite Folie 4 ebenfalls in bereits ausgeschnittene Form manuell in die zweite Formhälfte 9B gesetzt (Fig. 14A). In einem nachfolgenden Schritt des Schließens wird die Schließkraft F_{S} aufgebracht, wobei zugleich die erste Folie 2 und die zweite Folie 4 mit Unterdruck beaufschlagt werden. Bei Beibehaltung des Unterdrucks wird gemäß Fig. 14C das Spritzgussmaterial 3 eingefüllt, und man erhält gemäß Fig. 14D nunmehr abermals nach einem Öffnen der Formhälften 9A/B einen Körper 1.

Nach der Darstellung des Herstellungsverfahrens für den Körper 1 folgt nun die Angabe einiger wichtiger Werte.

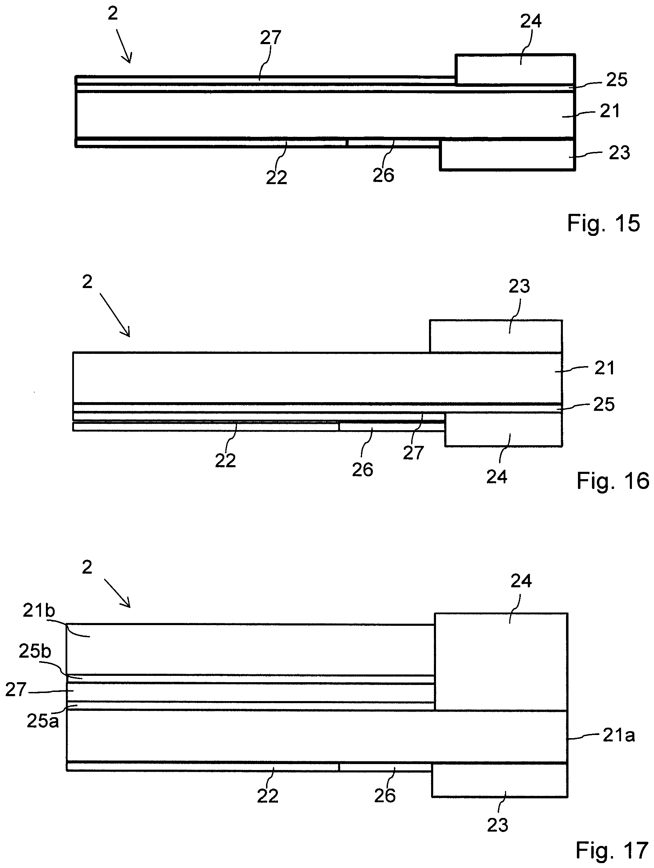

Bei dem in Fig. 15 gezeigten Schichtaufbau für die erste Folie 2 besteht das Substrat 21 aus Kunststoff, beispielsweise Polyethylenterephthalat, Polypropylen, Polycarbonat, Polyethylennaphthalat, Polyamid und ähnlichem Material, wobei das Substrat 21 eine Schichtdicke von 12 bis 600 µm, typischerweise von 35 bis 60 µm aufweist.

Die elektrische Funktionsschicht wird vorliegend in Form einer Metallschicht bereitgestellt, die Silber, Kupfer, Aluminium, Chrom oder andere Metalle oder Metallverbindungen und -legierungen umfasst. Die Schichtdicke dieser Metallschicht beträgt zwischen 10 und 150 nm, typischerweise zwischen 30 und 60 nm. Die Metallschicht ist insbesondere nicht durchgängig, sondern umfasst metallische Leiterbahnen in einem entweder besonders regelmäßigen oder gerade unregelmäßigen Muster, wobei die Leiterbahnen jeweils eine Breite von zwischen 1 µm und 40 µm aufweisen, bevorzugt etwa 5 µm und 20 µm, und einen Abstand von zwischen 100 µm und 5 mm zueinander haben, bevorzugt von zwischen 300 µm und 1 mm. Solche metallischen Leiterbahnen sind mit dem menschlichen Auge ohne Hilfsmittel nicht erkennbar. Dadurch wirkt die elektrische Funktionsschicht 25 transparent, obwohl elektrische Bauelemente bereitgestellt sind. Etwa bei einer Tastfeldfunktionalität sind die einzelnen Tastfelder durch elektrische Leiterbahnen gebildet, die galvanisch miteinander gekoppelt sind. Die kapazitive Koppelung erfolgt zu anderen Tastfeldern, die nicht galvanisch mit diesen Leiterbahnen gekoppelt sind und ihrerseits eine Mehrzahl von metallischen Leiterbahnen aufweisen, die untereinander galvanisch miteinander gekoppelt sind.

Die Erfindung ist nicht auf die Verwendung von metallischen Leiterbahnen zur Bereitstellung einer Tastfeldfunktionalität eingeschränkt. Jegliche leitenden und halbleitenden Elemente können zur Bereitstellung elektrischer und elektronischer Bauelemente beitragen. Beispielsweise können Metalle in Form von Nanodrähten (etwa aus Silber, Kupfer oder Gold) oder Nanopartikeln (etwa aus Silber, Gold oder Kupfer) bereitgestellt sein, es können Kohlenstoffnanoröhrchen oder Kohlenstoffnanopartikeln bereitgestellt sein, oder es können Elemente aus Graphen vorgesehen sein. Außerdem können organische Leiter aus PEDOT/PSS (Poly-3,4-ethylendioxythiophen/Polystyrolsulfonat) oder aus PAni (Polyanilin) bereitgestellt sein. Insbesondere können aktive elektrische Bauteile wie beispielsweise organische Leuchtdioden, anorganische oder organische Photovoltaikzellen, andere Displayelemente wie etwa aus Elektrolumineszenzmaterialien, elektrochromen Materialien oder elektrophoretischen Materialien vorgesehen sein, es können integrierte Schaltungen oder anorganische oder organische Speicher vorgesehen sein. All dies kann im Rahmen der vorliegenden Erfindung gleichermaßen eingesetzt werden. Dies gilt für alle in dieser Anmeldung beschriebenen Schichtaufbauten und -abfolgen und alle genannten Herstellungsverfahren.

Die Schutzschicht 27 auf der elektrischen Funktionsschicht 25 besteht beispielsweise aus Polyacrylat, Polyvinylchlorid, Polyvinylacetat, Polyurethan, Polycarbonat, Polyester, einem Ethylenvinylacetatcopolymer, einem Kohlenwasserstoffharz, chloriertem Polyolefin, Polyvinylalkohol, Melaminharz, Keton-/Formaldehydharz, Polyvinylidenfluorid, Epoxidharz, Polystyrol, einer polymeren Celluloseverbindung, Phenolharz, Polyamid, polymeren Flüssigkristallen (LCP), Harnstoffharz und Kunstharz, oder aus Kombination dieser Stoffe. Dies schließt sowohl thermisch als auch strahlengehärtete Lacksysteme ein.

Zur besseren Lackierbarkeit und Erhöhung der Oberflächengüte, wie z. B. der Kratzfestigkeit der entsprechenden Lackschichten, können verschiedene Additive dem Basislack zugesetzt werden. Es eignen sich Benetzungsadditive, Verlaufsadditive, Entschäumer und Füllstoffe wie z. B. nanoskallierte Silicas.

Die Schichtdicke der Schutzschicht 27 beträgt zwischen 1 und 25 µm, bevorzugt zwischen 2 und 6 µm.

Die elektrische Kontaktverstärkung 24 besteht beispielsweise aus dem mit "Carbon Black" bezeichneten Material, oder auch aus Leitsilber im Kontaktierungsbereich. Die Schichtdicke liegt typischerweise zwischen 1 und 15 µm.

Das Haftvermittlermaterial 22 (Primer) ist in Fig. 15 als eine einzelne Schicht gezeigt. Diese Schicht hat eine Schichtdicke von zwischen 1 und 9 µm, vorzugsweise von zwischen 1 und 5 µm. Sie besteht vorzugsweise aus folgendem Material:

| Komponente | Anteil (%) |
|---|---|
| Methylethylketon | 60 |
| Butylacetat | 15 |
| MMA Polymer (Tg: 100°C) | 7 |
| MMA/EA-Copolymer (Tg: 35°C) | 13 |
| Silica (SiO2) | 5 |

Hierbei ist Tg die Glastemperatur (Einfriertemperatur) der jeweiligen Komponente.

Bei einer Alternative kann die Haftvermittlerschicht 22 auch zweischichtig sein. In diesem Fall umfasst sie zusätzlich zu der gerade beschriebenen Schicht einen weitere Schicht mit einer Schichtdicke von zwischen 1 und 8 µm, bevorzugt von zwischen 1 und 4 µm in folgender Zusammensetzung:

| Komponente | Anteil (%) |
|---|---|
| Methylethylketon | 25 |
| Cyclohexanon | 10 |
| Ethylacetat | 32 |
| MMA Polymer (Tg: 105°C) | 15 |
| Acrylsäureester (Dichte=1,102 g/cm³) | 15 |
| Photoinitiator (Schmelzpunkt 45-49°C) | 3 |

Die erstgenannte Schicht befindet sich dabei stets an der Grenzfläche zwischen der Sensorfolie und dem Spritzgussmaterial (d. h. sie berührt das Spritzgussmaterial). Die zusätzliche Schicht ist hierbei so angeordnet, dass sie sich zwischen der erstgenannten Schicht und der Sensorfolie befindet.

Die die Haftung an dem Spritzgussmaterial unterdrückende Schicht 26 umfasst bevorzugt ein geeignetes Wachsmaterial oder dergleichen.

Als Spritzgussmaterial 3 können sämtliche thermoplastischen Kunststoffe eingesetzt werden, bevorzugt sind dies Polymethyl(meth)Acrylat, Acryl-Nitril-Butadien-Styrol, Polycarbonat oder Polyamid.

Das Spritzgießmaterial kann farbig oder transparent sein. Es kann Füllstoffe wie Glasfasern oder Carbonfasern umfassen, oder auch ohne Füllstoffe vorgesehen sein.

Das Verstärkungselement besteht vorzugsweise aus Kunststoff, wobei sich insbesondere Polyethylenterephthalat, Polypropylen, Polycarbonat, Polyethylennaphthalat eignen, vorzugsweise in einer Dicke aus dem Intervall von 12 - 150 µm, besonders bevorzugt aus dem Intervall von 35 - 60 µm.

Neben dem in Figur 15 gezeigten Schichtaufbau, bei dem das Substrat 21 die Haftvermittlerschicht 22 bzw. zwei Teilschichten der Haftvermittlerschicht 22 trägt, und bei der somit das Substrat 21 zwischen der elektrischen Funktionsschicht und dem Spritzgussmaterial angeordnet ist, gibt es eine Variante, bei der die Situation genau umgekehrt ist: Das die elektrische Funktionsschicht 25 und die Schutzschicht 27 tragende Substrat 21 weist von dem Spritzgussmaterial 3 weg, und es ist die Schutzschicht 27 (oder gegebenenfalls unmittelbar die elektrische Funktionsschicht 25), welche die Haftvermittlerschicht 22 (bzw. zwei Teilschichten derselben) trägt und das optionale Anti-Haft-Material in der die Haftung unterdrückenden Schicht 26. Diese Situation ist in Figur 16 dargestellt. Bei dieser Situation ist auch die Anordnung des Verstärkungselements 23 und der Kontaktverstärkung 24 vertauscht.

In anderer Abwandlung der Ausführungsform gemäß Figur 15 ist die zweite Folie 2 ein Mehrschichtkörper mit einer Mehrzahl von elektrischen Funktionsschichten. In diesem Falle gibt es ein erstes Substrat 21a, und darauf die elektrische Funktionsschicht 25a. Diese trägt wiederum eine Schutzschicht 27, auf der sich die zweite elektrische Funktionsschicht 25b befindet, und darauf befindet sich ein zweites Substrat 21b. Ansonsten entspricht der Schichtaufbau dem in Figur 15 Gezeigten, und das zu diesem Schichtaufbau Ausgeführte gilt entsprechend für die Ausführungsform gemäß Figur 17.

Mehrere elektrische Funktionsschichten können beispielsweise bei der Verwendung kapazitiver Bauelemente vorkommen, die nicht einlagig bereitgestellt werden, etwa durch die oben genannten metallischen Leiterbahnen, sondern zweilagig.

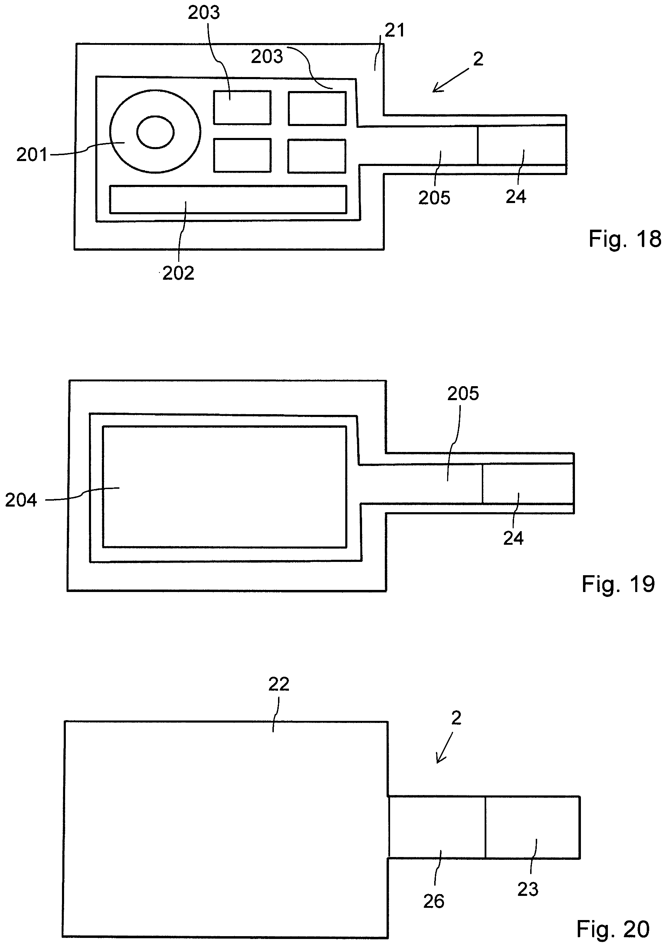

Eine erste Folie 2 ist in unterschiedlichen Ausführungen in Draufsicht in den Figuren 18 und 19 dargestellt. Im Falle der Figur 19 kann man aktive Bereiche erkennen, wie beispielsweise einen Drehregler 201, einen Schieberegler 202 und Taster 203.

Die Ausgestaltung dieser Elemente ist an sich bekannt und muss vorliegend nicht erläutert werden.

Alternativ kann ein Touchscreen (Tastfeldeinheit) 204 bereitgestellt sein, siehe Figur 19. In dem außerhalb der bisher bezeichneten Bereiche zu sehenden Bereich 205 sind elektrische Verbindungsleitungen vorgesehen, die bis zu der Kontaktverstärkung 24 führen.

Die Figur 20 zeigt die zweite Folie 2 von unten mit den Bereichen, die mit einem Haftvermittler 22 versehen sind, die mit einem die Haftung unterdrückenden Material 26 versehen sind, und die ferner das Verstärkungselement 23 umfassen. Anhand von Figur 20 wird besonders gut ersichtlich, wie in dem späteren Körper 1 gemäß Figur 1 dafür gesorgt werden kann, dass ein Fähnchen von dem Spritzgussmaterial 3 wegstehen kann, vgl. auch die obigen Erläuterungen zu den Figuren 12a - 12c.

Die bisherige Beschreibung des Herstellungsverfahrens für den Körper 1 beruhte darauf, dass eine Haftvermittlerschicht 22 und/oder eine die Haftung unterdrückende Schicht 26 vorgesehen wird.

Nachfolgend sollen noch weitere Herstellungsverfahren erläutert werden, bei denen unterschiedliche Werkzeuge eingesetzt werden, und bei denen auf mechanische Art und Weise dafür gesorgt wird, dass bei dem fertigen Körper 1 aus Figur 1 ein Fähnchen im zweiten Bereich 22b weg steht.

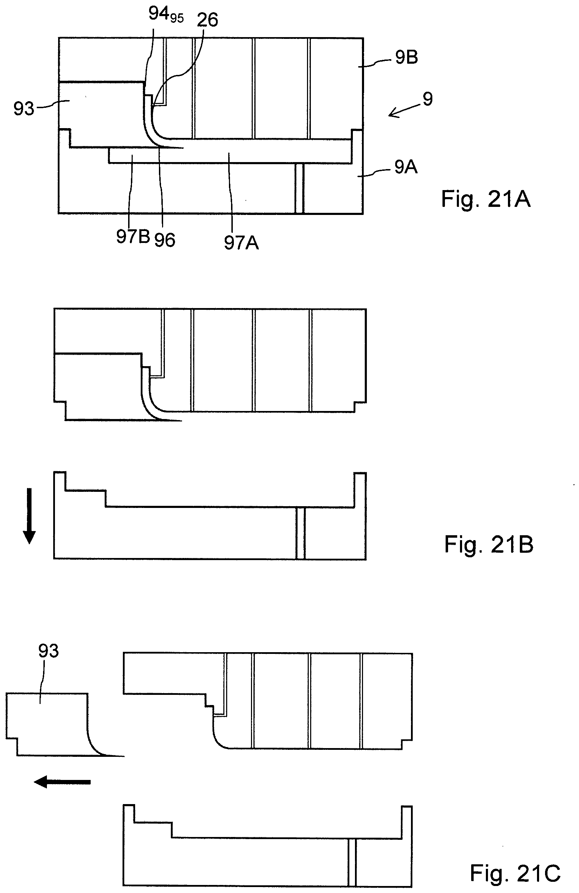

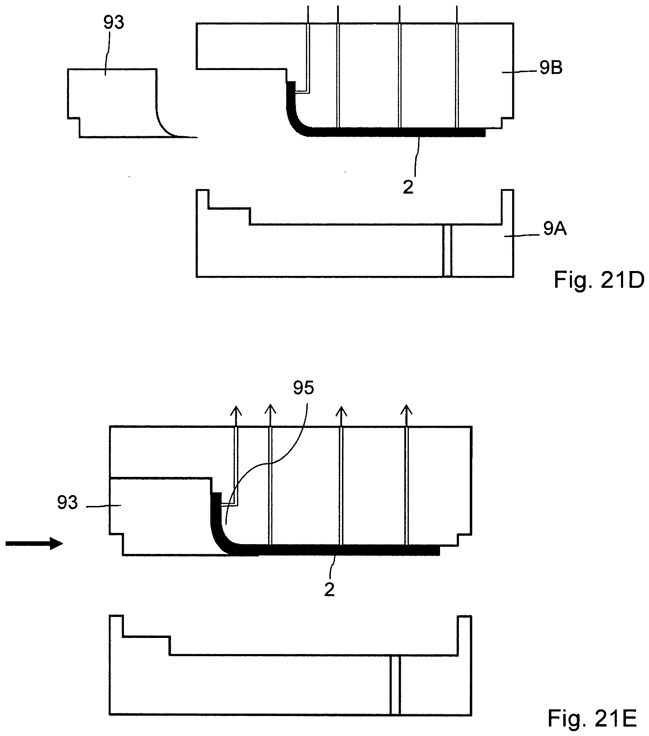

Bei den nachfolgend beschriebenen Ausführungsformen ist die zweite Folie 4 nicht beschrieben. Die Verfahren können gleichermaßen aber auch dann vorgesehen werden, wenn eine solche zweite Folie nach einem Rolle-zu-Rolle-Verfahren oder manuellem Einlegen gleichzeitig mit der ersten Folie hinterspritzt werden sollen. Das oben bezüglich der Figuren 13A - 13D und 14A - 14D beschriebene Vorgehen kann jeweils entsprechend auch in Verbindung mit den nachfolgend unter Bezug auf die Figuren 21A - 21H, 22A - 22H, 23A - 23H und 24A - 24H beschriebenen Verfahren vorgesehen werden.

Alternativ oder zusätzlich zum Vorsehen der zweiten Folie 4 kann auch die erste Folie eine Dekorschicht tragen.

Bei einem dritten Verfahren zur Herstellung des Körpers 1 nach Figur 1 wird eine Spritzgussform 9 mit zwei Formhälften 9A und 9B eingesetzt, wobei die Spritzgussform 9 zusätzlich über einen Schieber 93 verfügt. Die Spritzgussformhälfte 9B verfügt hierbei über eine solche Form, dass sich eine Folie nach Art der zweiten Folie 2 mit einem Ende umbiegt. In diesem Ende ist genau der Schieber 93 vorgesehen, und zwar stößt der Schieber 93 an einem Anschlag 94 an, der so bemessen ist, dass gerade die typische erste Folie 2 genau zwischen den Schieber 93 und eine Oberfläche 95 der zweiten Spritzgussformhälfte 9B passt. Der Schieber 93 weist einen spitzen Vorsprung 96 auf, der geeignet ist, die zweite Folie 2 von einem Teil 97B der Spritzgusskavität abzutrennen, der sich an einen ersten Teil 97A anschließt.

Während die Figur 21A die Spritzgussform im geschlossenen Zustand zeigt, zeigt die Figur 21B, dass die Form geöffnet ist, und 21C zeigt, dass der Schieber 93 ausgefahren ist. Figur 21D veranschaulicht dann, dass eine erste Folie 2 eingesetzt ist, welche durch Vakuum (siehe die Pfeile) an die zweite Spritzgussformhälfte 9B angeschmiegt wird. Nun wird der Schieber 93 eingefahren, und zwar mit einem solchen Druck, dass die zweite Folie 2 und deren elektrische Funktionsschicht 25 nicht beschädigt wird; gleichwohl ist der Druck ausreichend hoch, um die zweite Folie 2 in ihrem eingeklemmten Bereich zwischen dem Schieber 93 und der Oberfläche 95 von dem Spritzgussmaterial abzutrennen.

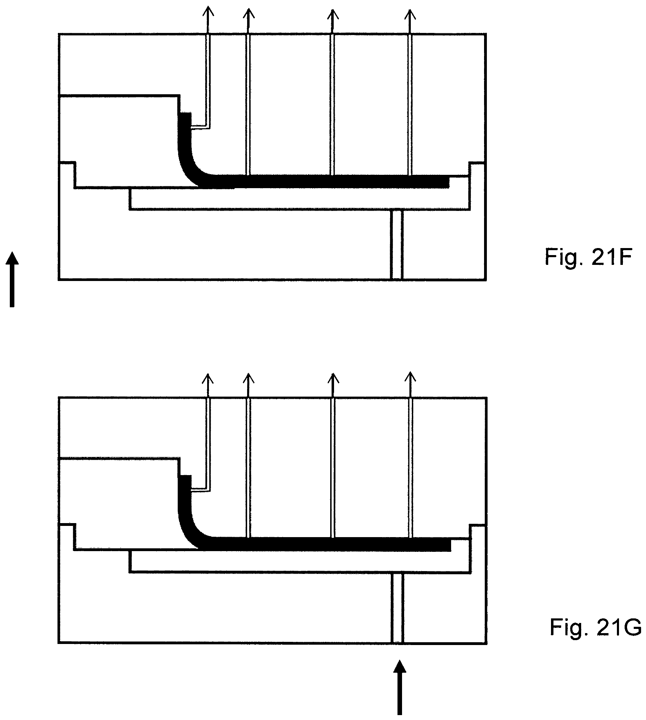

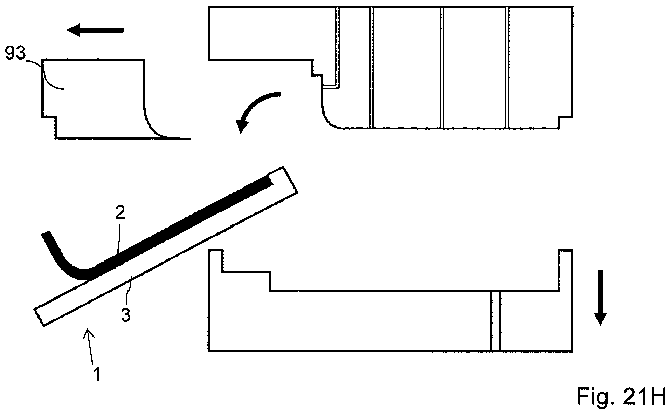

Nachfolgend wird gemäß Figur 21F die Spritzgussform geschlossen, und es wird gemäß Figur 21G Spritzgussmaterial 3 eingespritzt. Nach dem Öffnen der Spritzgussform und dem Herausfahren des Schiebers 93 kann, wie in Figur 21H schematisch gezeigt, der fertige Körper 1 herausgenommen werden.

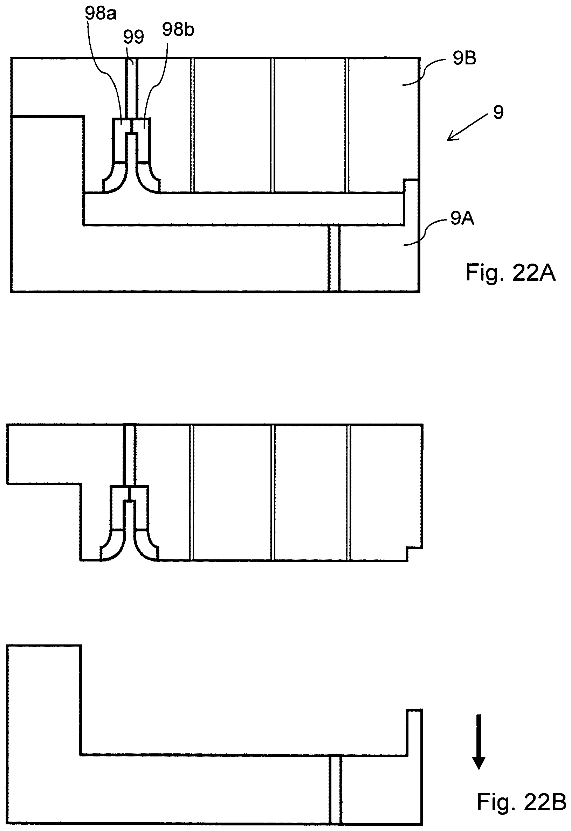

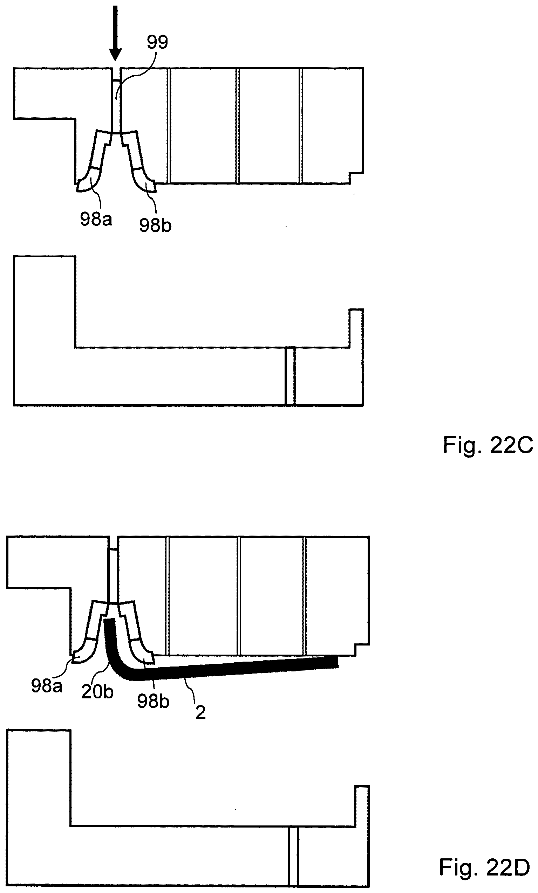

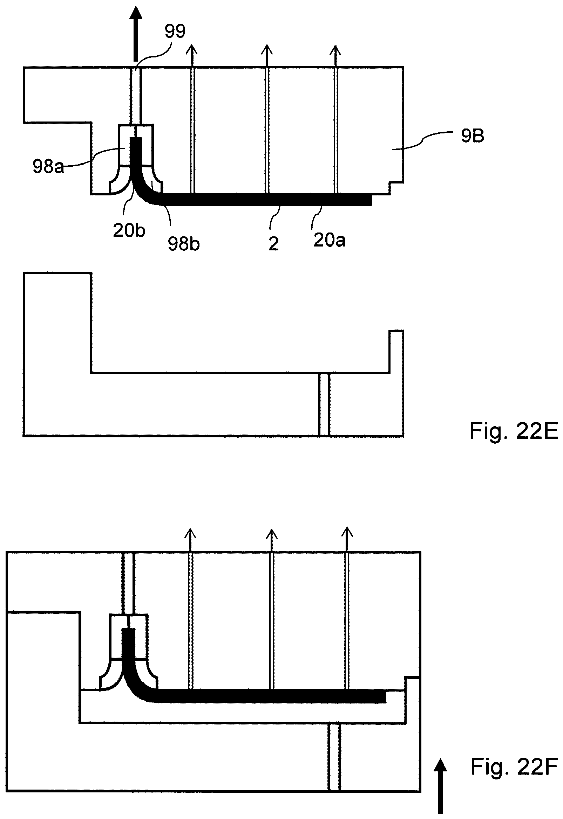

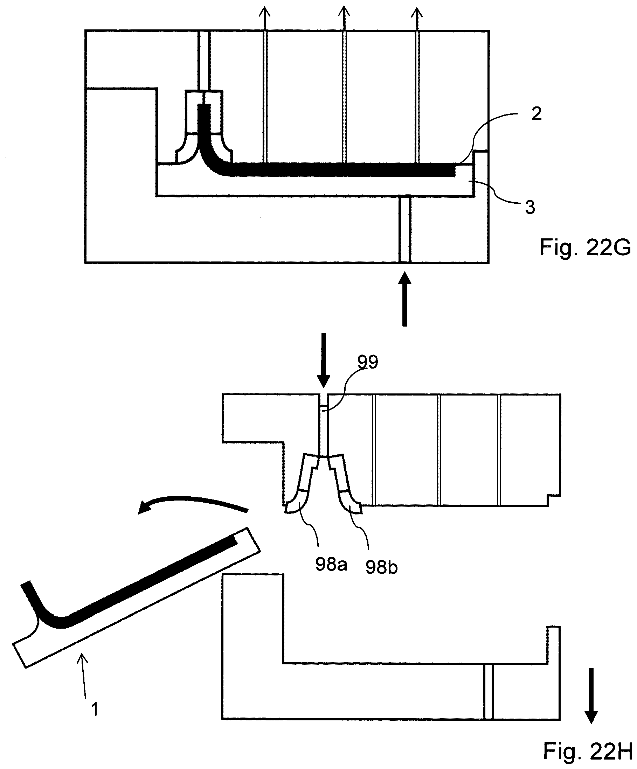

Bei einem vierten Verfahren zur Herstellung des Körpers 1 wird die in Figur 22A im geschlossenen Zustand gezeigte Spritzgussform 9 eingesetzt. Diese weist in einer zweiten Formhälfte 9B zwei Klemmbacken 98a und 98b auf, wobei diese Klemmbacken von einem Faltkern 99 auseinander und wieder zusammengeführt werden können. Anhand Figur 22B wird ersichtlich, dass die Spritzgussform 9 geöffnet wird, sodann wird durch Herunterfahren des Faltkerns 99 ein Sich-Öffnen der Klemmbacken 98a und 98b bewirkt, siehe Figur 22C, sodann kann eine zweite Folie 2 mit einem zweiten Abschnitt 20b zwischen die beiden Klemmbacken 98a und 98b geschoben werden (Figur 22D), und gemäß Figur 22E werden die Klemmbacken durch Wiederhochfahren des Faltkerns 99 geschlossen, sodass der zweite Bereich 20b der zweiten Folie 2 zwischen den beiden Klemmbacken 98a und 98b festgeklemmt wird.

Gleichzeitig wird, wie durch die Pfeile in Figur 22E angedeutet, die erste Folie 2 in einem ersten Bereich 20a mit Unterdruck beaufschlagt, sodass sie sich an die Formhälfte 9B anschmiegt. Sodann wird die Spritzgussform geschlossen (siehe Figur 22F), es wird Spritzgussmaterial 3 eingespritzt, sodass die erste Folie 2 hinterspritzt wird, siehe Figur 22G, und nachfolgend kann bei geöffneter Spritzgussform und geöffneten Klemmbacken 98a und 98b der Körper 1 entnommen werden.

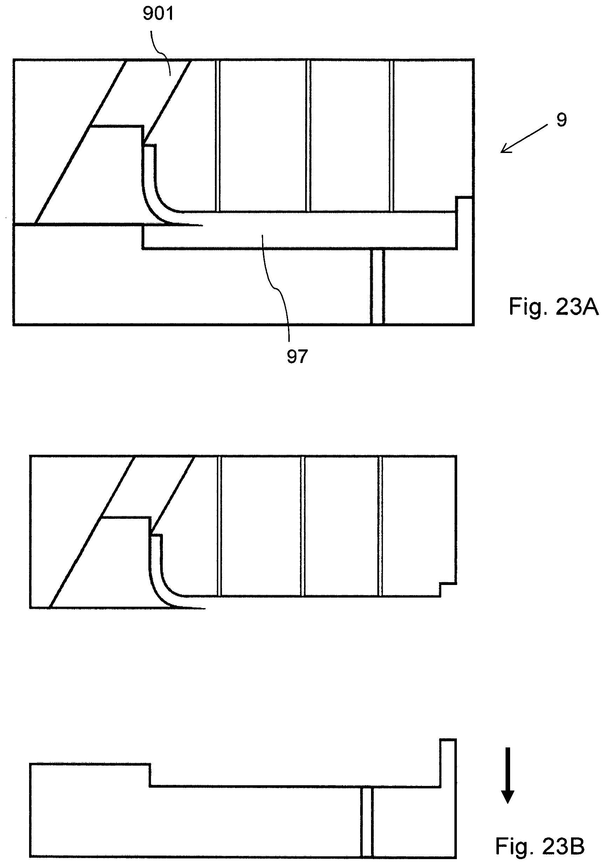

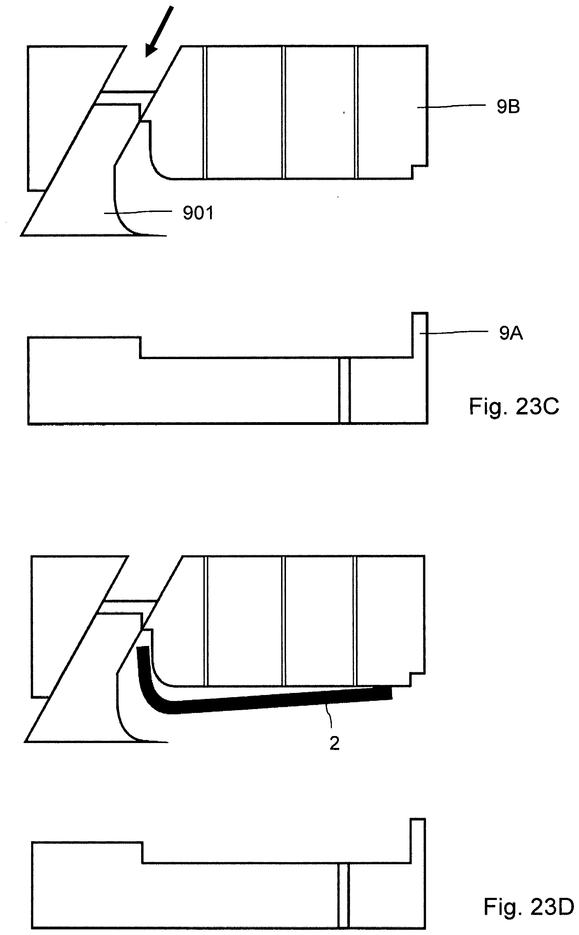

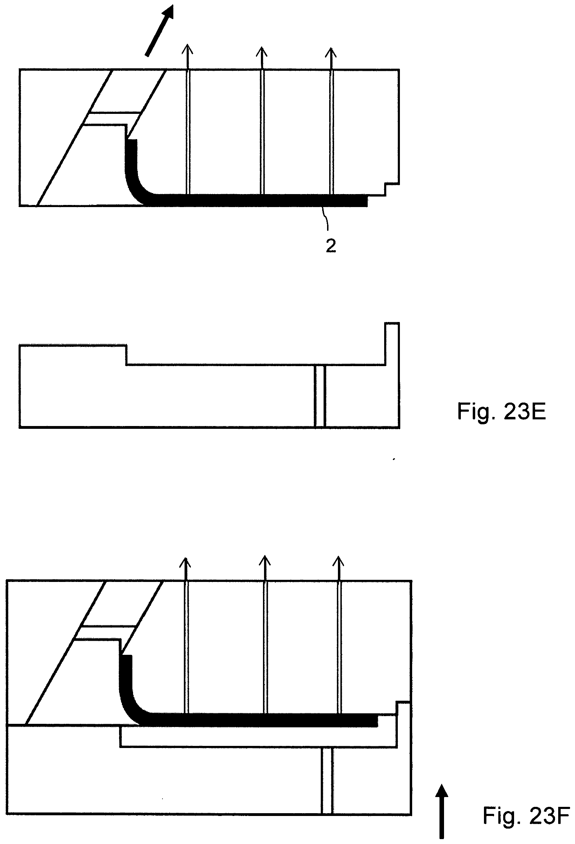

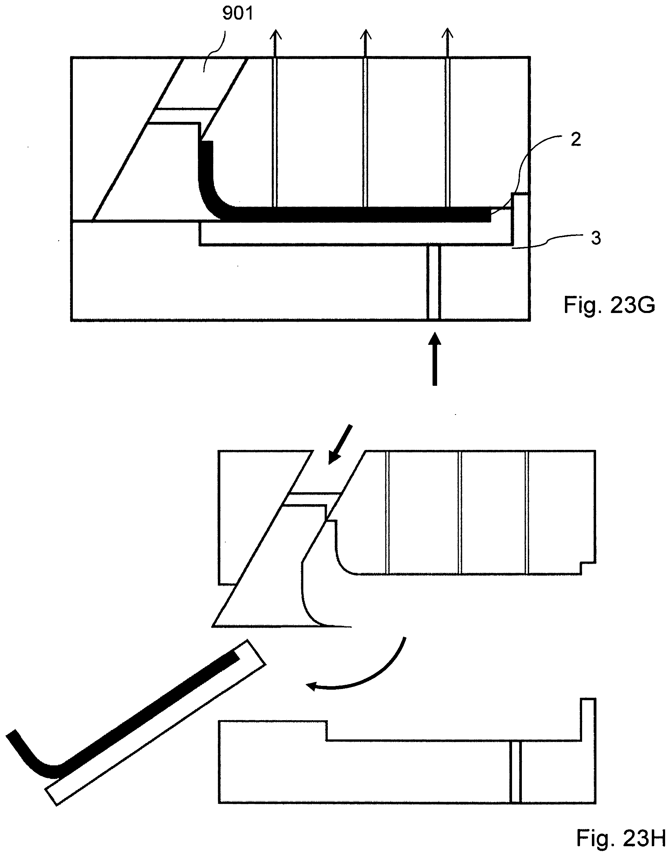

Eine fünfte Ausführungsform des Verfahrens zur Herstellung des Körpers 1 macht Gebrauch von dem in Figur 23 eingeschlossenen Zustand gezeigten Spritzgusswerkzeug 9. Dieses weist einen Schrägauswerfer 901 auf. Der Schrägauswerfer 901 hat zum Innern der Kavität 97 des Spritzgusswerkzeugs 9 hin im Wesentlichen die selbe Form wie sie der Schieber 93 aus den Figuren 21A - 21H hat. Das zu dem Schieber 93 oben Ausgeführte gilt entsprechend für den Schrägauswerfer 901, nur dass der Schrägauswerfer 901, wie in Figur 23C zu sehen, in der Spritzgussformhälfte 9B aufgenommen ist und schräg ausgefahren wird. Ansonsten entsprechen die Schritte aus Figur 23A - 23H genau denen, die oben unter Bezug auf die Figuren 21A - 21H beschrieben wurden.

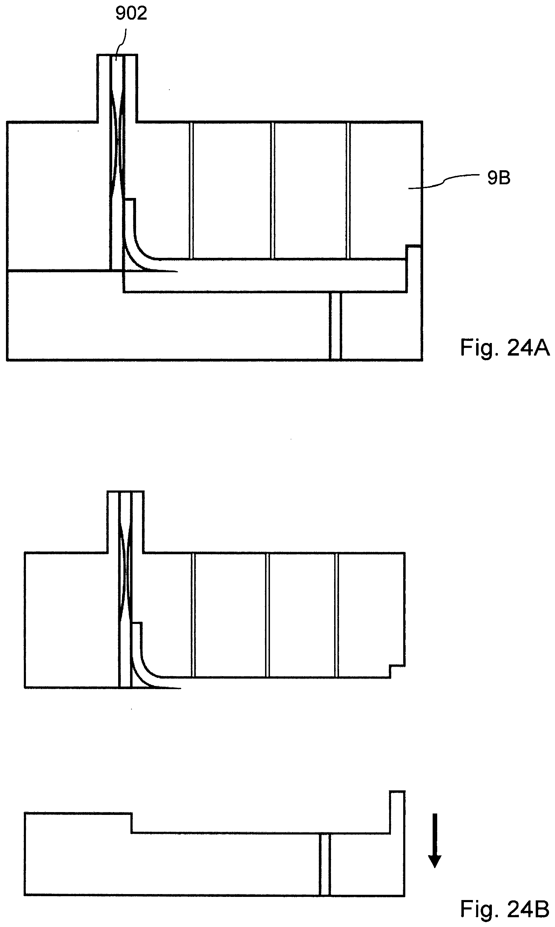

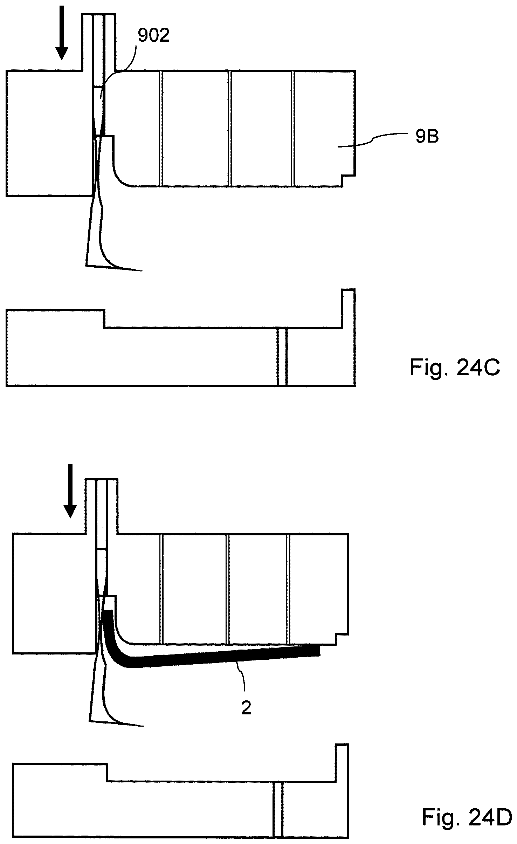

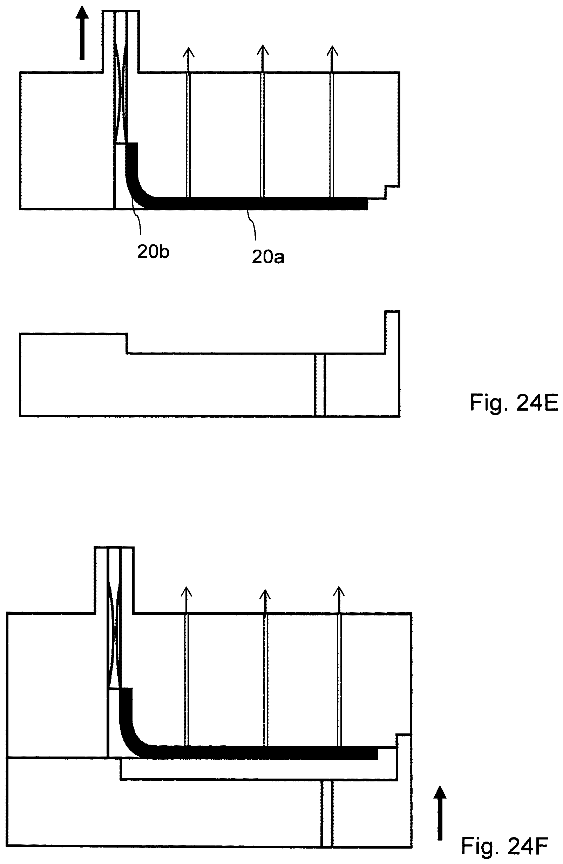

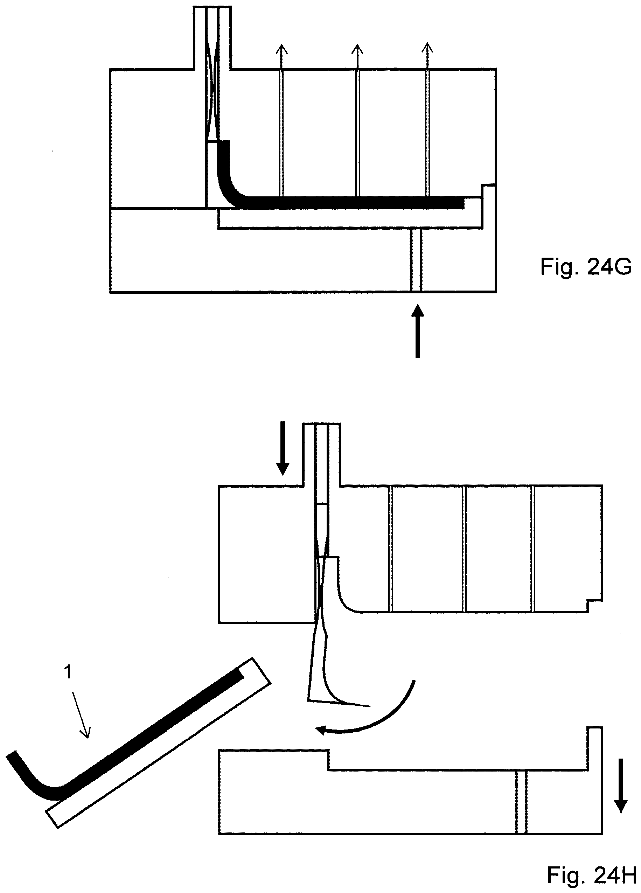

Bei einer anhand der Figuren 24A - 24H ersichtlich werden den sechsten Ausführungsform des erfindungsgemäßen Verfahrens kommt ein in der Spritzgussformhälfte 9B gelagerter federnder Auswerfer 902 zum Einsatz. Die Schritte des Öffnens der Spritzgussform, des Ausfahrens des Auswerfers 902, des Einlegens der ersten Folie 2, des Abklemmens von deren zweiten Bereich 20b und gleichzeitig des Ansaugens des ersten Bereichs 20a derselben sowie des nachfolgenden Hinterspritzens und des Entnehmens bzw. Herauswerfens des fertigen Körpers 1 sind anhand der Figuren 24A - 24H ersichtlich.

Beim Spritzgießen von Polymethylmethacrylat werden üblicherweise Einspritzdruckgrößen von 800 - 1800 bar bei einer Temperatur der Spritzgussformhälften 9A und 9B von 50 - 90°Celsius verwirklicht, die in den Figuren nicht gezeigte Einspritzeinheit hat typische Temperaturen von zwischen 250° und 280°Celsius. Das Einspritzen kann beispielsweise innerhalb einer Sekunde erfolgen. Die Abkühlzeit kann 12 Sekunden betragen. Insgesamt kann in einem Rhythmus von 25 Sekunden ein Körper hergestellt werden.

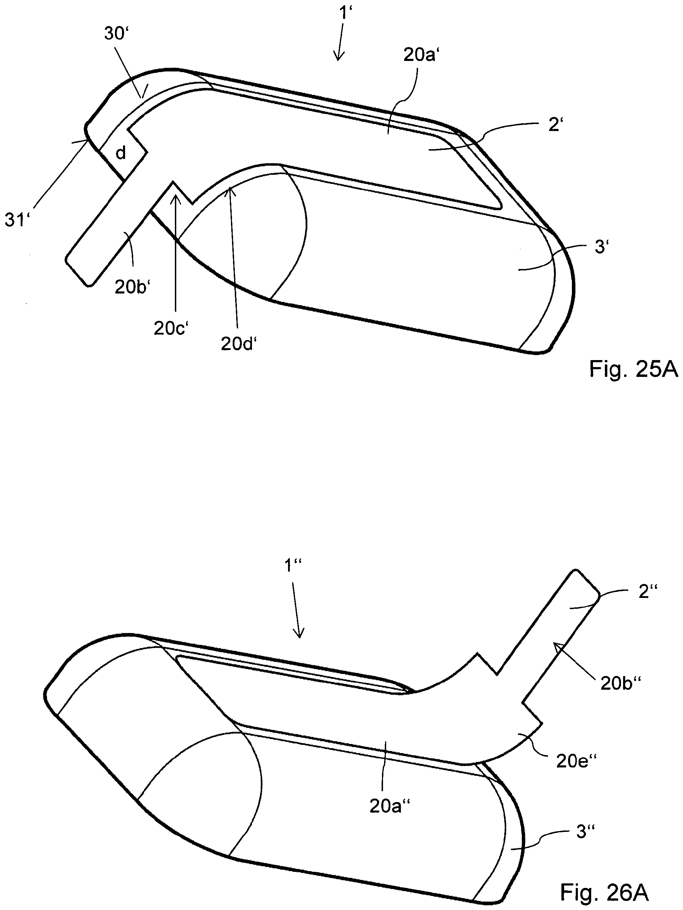

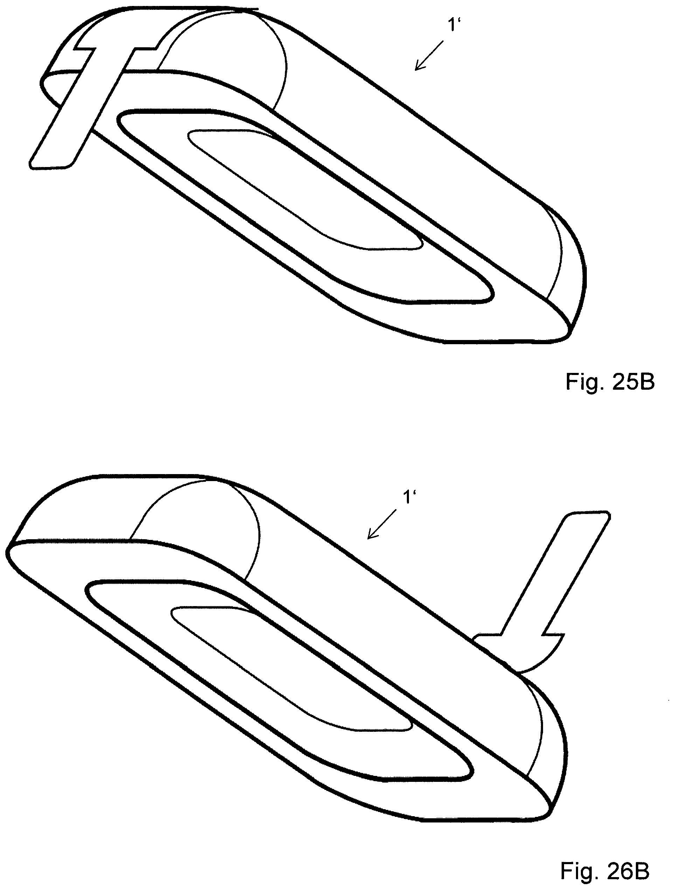

Bei allen bisher beschriebenen Ausführungsformen des Körpers 1 ist dieser als im Wesentlichen ebene Platte ausgeführt, von der das Fähnchen F weg steht. Die Figuren 25A und 25B zeigen eine weitere Ausführungsform des erfindungsgemäßen Körpers 1', die Figuren 26A und 26B eine Abwandlung 1" dieses Körpers 1'.

Bei diesem Körper ist eine gekrümmte Oberfläche vorgesehen, über die sich die erste Folie 2' zumindest teilweise erstreckt. Insbesondere ist der erste Abschnitt 20a' der ersten Folie 2' zum Teil über eine Krümmung geführt, siehe den Bereich 20d'. Auch hier gibt es einen zweiten Bereich 20b', der nach Art einer Zunge von dem ersten Bereich 20a' weg steht, wobei der Übergangsbereich 20c' genau der Bereich ist, wo das Anhaften der ersten Folie 2' an dem darunter befindlichen Spritzgussmaterial 3' endet. Der zweite Bereich 20b' kann also wie ein Fähnchen hin und her bewegt werden. Der Angelpunkt dieser Bewegung ist der Übergangsbereich 20c', der Abstand d' zum Rand 31' hat, welcher die Oberfläche 30' des Spritzgussmaterials 3' mit der ersten Folie 2' begrenzt.

Bei einer zu der Form des Spritzgussmaterials aus Figur 25a analogen Ausführungsform gemäß Figur 26A ist zwar der Körper 1" als Ganzes mit einer gekrümmten Oberfläche versehen, die erste Folie 2" befindet sich jedoch auf einem ebenen Teil dieser Oberfläche. Es gibt einen ersten Bereich 20a", der an dem Spritzgussmaterial 3" haftet. Vorliegend steht nicht nur ein zungenförmiger Teil 20b" weg, sondern auch ein Teil 20e" des eigentlichen Funktionsbereiches.

Der dreidimensionale Körper 1' oder der dreidimensionale Körper 1" aus Figur 25a/b bzw. 26 a/b sollen nur exemplarisch veranschaulichen, dass ganz andere Ausführungsformen der Erfindung verwirklicht werden könnten.

Die oben zu dem im Wesentlichen plattenförmigen Körper 1 beschriebenen Herstellungsverfahren lassen sich, unter Anpassung der Spritzgussformen, entsprechend auch bei einem dreidimensionalen Körper nach Art der Körper 1' und 1" verwirklichen.

### Bezugszeichenliste

- 1, 1', 1": Körper
- 2, 2', 2": erste Folie
- 3, 3', 3": Kunststoffhauptmaterial
- 4: zweite Folie
- 5: Gehäuse
- 6: elektrisches bzw. elektronisches Bauteil
- 7: Leuchtelemente
- 8: Steckverbindung
- 9: Spritzgussform
- 9A/B: Formhälfte
- 11a, 11b: Bereich am Rand des Gehäuseteils 5
- 20a, 20a', 20a": Funktionsbereich
- 20b, 20b', 20b": Kontaktierungsbereich
- 20c, 20c', 20c": Oberflächenbereich
- 21, 21', 21": tragendes Substrat
- 21a: erstes Substrat
- 21b: zweites Substrat
- 22: Haftvermittlerschicht
- 23: Verstärkungselement
- 24: Kontaktverstärkung
- 25: Funktionsschicht
- 26: unterdrückende Schicht
- 27: Zusatzschicht
- 30: Oberfläche
- 31, 31': begrenzender Rand
- 41: Trägerschicht
- 42: Übertragungslage
- 43a: erste Rolle
- 43b: zweite Rolle
- 91: Zufuhrleitung
- 93: gesonderter Schieber
- 94: Anschlag
- 95: Oberfläche
- 98a, 98b: voneinander trennbare Klemmbacken
- 99: Faltkern
- 100: elektrisches Gerät
- 201: Drehregler
- 202: Schieberegler
- 203: Taster
- 204: Touchscreen (Tastfeldeinheit)
- 901: Schrägauswerfer
- 902: Federauswerfer
- d, d': Abstände
- F: Fähnchen
- F_{S}: Schließkraft
- F_{Ö}: Öffnungskraft

## Patentansprüche

1. Körper (1, 1', 1"), der eine erste Folie (2, 2', 2") mit zumindest einer elektrischen oder elektronischen Funktionsschicht (25) auf einem Substrat aus Kunststoff (21) aufweist, wobei in einem Funktionsbereich (20a, 20a', 20a") der Funktionsschicht zumindest ein elektrisches und/oder elektronisches Bauelement bereitgestellt ist, und wobei in einem Kontaktierungsbereich (20b, 20b', 20b") der zumindest einen Funktionsschicht (25) zumindest ein elektrischer Anschluss vorgesehen ist, welcher galvanisch mit zumindest einem Bauelement gekoppelt ist, wobei der Körper (1) ferner ein Kunststoffhauptmaterial (3, 3', 3") umfasst, wobei sich die Hafteigenschaften zwischen der ersten Folie (2, 2', 2") und dem Kunststoffhauptmaterial (3, 3', 3") in einem ersten Bereich von denjenigen in einem zweiten Bereich unterscheiden und die erste Folie mit dem Kunststoffhauptmaterial (3, 3', 3") partiell so hinterspritzt ist, dass der Kontaktierungsbereich (20b, 20b', 20b") zumindest teilweise von Kunststoffhauptmaterial (3) frei ist, wobei die erste Folie (2, 2', 2") derart ausgebildet ist, dass durch einen nicht hinterspritzten Teil der ersten Folie (2, 2', 2") ein von dem Kunststoffhauptmaterial (3, 3', 3") getrenntes Fähnchen (F) bereitgestellt ist, welches sich an einen hinterspritzten Teil der ersten Folie in einem Oberflächenbereich (20c, 20c', 20c") des Körpers (1) anschließt, der von einem die Oberfläche (30) mit der ersten Folie begrenzenden Rand (31, 31') des Körpers beabstandet ist.

2. Körper (1, 1', 1") nach Anspruch 1, bei dem durch das Kunststoffhauptmaterial (3, 3', 3") eine Form des Körpers vorgegeben ist, die es erlaubt, das Fähnchen (F) zumindest partiell in Anlage an die Oberfläche des Kunststoffhauptmaterials auf dessen Seite mit der ersten Folie (2, 2', 2") zu bringen.

3. Körper (1) nach Anspruch1 oder 2, welcher eine ebene Oberfläche (30) aufweist, an der die erste Folie (2) angeordnet ist, und wobei das Fähnchen (F) in eine Lage verbringbar ist oder in einer Lage befindlich ist, in der es in einem Winkel vorzugsweise aus dem Intervall von 15° bis 90° zur Ebene von einem Oberflächenbereich weg steht, an den sich bezüglich der Oberfläche allseitig Kunststoffhauptmaterial anschließt.

4. Körper (1, 1") nach Anspruch 1 oder 2, welcher eine gekrümmte Oberfläche (30') aufweist, an der die erste Folie (2', 2") angeordnet ist, und wobei das Fähnchen in eine Lage verbringbar oder in einer Lage befindlich ist, in der es in einem Winkel vorzugsweise aus dem Intervall von 75° bis 0° zu einer Flächennormalen der gekrümmten Oberfläche an einem Oberflächenbereich weg steht, an den sich bezüglich der Oberfläche allseitig Kunststoffhauptmaterial anschließt.

5. Körper nach einem der vorhergehenden Ansprüche, bei dem ein Übergang (20c, 20c', 20c") von einem hinterspritzten Teil der ersten Folie (2, 2', 2") zu einem nicht hinterspritzten Teil der Folie längs einer Linie auf der Oberfläche erfolgt, die zumindest 2 mm, bevorzugt zumindest 3 mm, besonders bevorzugt zumindest 5 mm, ganz besonders bevorzugt zumindest 8 mm von einer die Oberfläche mit der ersten Folie (2, 2', 2") begrenzenden Randkontur des Körpers entfernt (d, d') ist.

6. Körper nach einem der vorhergehenden Ansprüche, der eine zweite Folie (4) oder ein Lackpaket aufweist, die bzw. das ebenfalls mit dem Kunststoffhauptmaterial hinterspritzt ist und eine vollflächige oder partielle Dekorschicht aufweist, welche vorzugsweise zumindest eine Information hinsichtlich des zumindest einen elektrischen und/oder elektronischen Bauelements bereitstellt.

7. Körper nach einem der vorhergehenden Ansprüche, mit einem Versteifungselement, insbesondere mit einer Dicke aus dem Intervall von 140 bis 580 µm, und/oder einem zusätzlichen Kontaktelement, insbesondere mit einer Dicke aus dem Intervall von 1 bis 15 µm, an dem Fähnchen.

8. Körper nach einem der vorhergehenden Ansprüche, bei dem die Funktionsschicht (25) eine Vielzahl von Leiterbahnen aufweist, die aus Metall, insbesondere aus Silber, Kupfer, Aluminium, Chrom, oder aus einer Metalllegierung bestehen, und die eine Breite von 100 µm oder mehr aufweisen, oder eine Breite von zwischen 1 µm und 40 µm aufweisen und einen Abstand von zwischen 10 µm und 5 mm zueinander haben und vorzugsweise in einer Schichtdicke von 10 bis 150 nm, besonders vorzugsweise von 30 bis 60 nm bereitgestellt sind.

9. Körper nach einem der Ansprüche 1 bis 7, bei dem die Funktionsschicht Metallnanodrähte, insbesondere aus Silber, Kupfer, Gold, Metallnanopartikeln, insbesondere aus Silber, Kupfer oder Gold, Kohlenstoffnanoröhrchen, Kohlenstoffnanopartikeln, Graphen, und/oder organische Leiter wie PEDOT/PSS und/oder Polyanilin umfasst und/oder aktive elektrische Bauteile bereitstellt, insbesondere organische Leuchtdioden, anorganische oder organische Photovoltaikzellen, unter Einsatz von Elektroluminizenzmaterialien, elektrochromen Materialien und/oder elektrophoretischen Materialien bereitgestellte Displayelemente, integrierte Schaltungen und/oder anorganische oder organische Speicher.

10. Körper nach einem der vorhergehenden Ansprüche, bei dem das tragende Substrat (21, 21', 21") aus Polyethylenterephthalat, Polypropylen, Polycarbonat, Polyethylennaphthalat besteht und vorzugsweise in einer Dicke von zwischen 12 bis 600 µm besonders bevorzugt von zwischen 35 bis 60 µm bereitgestellt ist, wobei das Substrat (21) zwischen der Funktionsschicht (25) und dem Kunststoffhauptmaterial (3) angeordnet ist, oder wobei
die Funktionsschicht (25) zwischen dem Substrat (21) und dem Kunststoffhauptmaterial (3) angeordnet ist.

11. Körper nach einem der vorhergehenden Ansprüche, mit einer Haftvermittlerschicht (22) zumindest an dem mit Kunststoff hinterspritzten Teil der ersten Folie (2), welche bevorzugt aus zwei Teilschichten besteht, welche aus unterschiedlichem Material gebildet sind.

12. Verfahren zum Herstellen eines Körpers (1), insbesondere eines Körpers (1) mit den Merkmalen nach einem der Ansprüche 1 bis 11, bei dem eine erste Folie (2) in eine Spritzgussform (9) eingelegt wird, wobei die erste Folie (2) in einem ersten Bereich (20a) Hafteigenschaften bezüglich eines vorbestimmten Spritzgussmaterials (3) aufweist, die qualitativ besser sind als die entsprechenden Hafteigenschaften in einem zweitem Bereich (20b) der ersten Folie (2), wobei der zweite Bereich (20b) die Form einer von dem ersten Bereich weg stehenden Zunge aufweist, wobei bei dem Verfahren in die Spritzgussform mit der ersten Folie das vorbestimmte Spritzgussmaterial (3) eingespritzt wird, sodass die erste Folie (2) partiell hinterspritzt wird und sodann der hergestellte Körper (1) entnommen wird, **dadurch gekennzeichnet, dass** die erste Folie (2) so in die Spritzgussform (9) eingelegt wird, dass aufgrund der Eigenschaften des ersten Bereichs (20a) und des zweiten Bereichs (20b) der ersten Folie (2) wegen der unterschiedlichen Hafteigenschaften Spritzgussmaterial (3) an der ersten Folie (2) in dem ersten Bereich (20a) anhaftet, Spritzgussmaterial (3) an der ersten Folie (2) in dem zweiten Bereich (20b) aber schlecht oder nicht anhaftet.

13. Verfahren nach Anspruch 12, bei welchem eine Folie eingelegt wird, die eine Haftvermittlerschicht (22) in dem ersten Bereich umfasst und/oder eine die Haftung unterdrückende Schicht (26) in dem zweiten Bereich (20b) umfasst.

14. Verfahren zum Herstellen eines Körpers mit den Merkmalen nach einem der Ansprüche 1 bis 11, bei dem eine erste Folie (2) in eine Spritzgussform (9) eingelegt wird, wobei die erste Folie (2) in einem ersten Bereich (20a) Hafteigenschaften bezüglich eines vorbestimmten Spritzgussmaterials (3) aufweist, die qualitativ besser sind als die entsprechenden Hafteigenschaften in einem zweitem Bereich (20b) der ersten Folie (2), wobei der zweite Bereich (20b) die Form einer von dem ersten Bereich weg stehenden Zunge aufweist, und wobei bei dem Verfahren der zweite Bereich (20b) zwischen zwei Klemmteilen (9B, 93, 98a, 98b, 901, 902) eingeklemmt wird, und wobei Spritzgussmaterial (3) in die Spritzgussform (9) eingespritzt wird und so der erste Bereich (20a) der ersten Folie (2) hinterspritzt wird, wobei
a) die Klemmelemente eine Formhälfte (9B) der Spritzgussform und entweder einen gesonderten Schieber (93) oder einen in der Formhälfte der Spritzgussform gelagerten Federauswerfer (902) umfassen oder
b) die Klemmelemente zwei durch einen Faltkern (99) voneinander trennbare Klemmbacken (98a, 98b) umfassen.

15. Verfahren nach einem der Ansprüche 12 bis 14, bei dem eine zweite Folie in die Spritzgussform eingebracht wird, die ebenfalls hinterspritzt wird, und die eine Trägerschicht (41) und eine Übertragungslage (42) umfasst und in einem Rolle-zu-Rolle-Verfahren zugeführt wird, wobei nach dem Hinterspritzen die Übertragungslage (42) zumindest partiell an dem Spritzgussmaterial (3) haftet und von der Trägerschicht (41) abgelöst wird und wobei die Trägerschicht (41) im Rolle-zu-Rolle-Verfahren abgeführt wird.

## Claims

1. Body (1, 1', 1"), which has a first film (2, 2', 2") having at least one electrical or electronic functional layer (25) on a substrate made of plastic (21), wherein, in a functional region (20a, 20a', 20a") of the functional layer, at least one electrical and/or electronic component is provided, and wherein, in a contacting region (20b, 20b', 20b") of the at least one functional layer (25), at least one electrical connection is provided, which is galvanically coupled to at least one component, wherein the body (1) further comprises a plastic main material (3, 3', 3"), wherein the adhesion properties between the first film (2, 2', 2") and the plastic main material (3, 3', 3") in a first region differ from those in a second region, and the first film is partially back-injected with the plastic main material (3, 3', 3") in such a way that the contacting region (20b, 20b', 20b") is at least partially free from plastic main material (3), wherein the first film (2, 2', 2") is designed in such a way that, by means of a part, which is not back-injected, of the first film (2, 2', 2"), a flag (F) which is separated from the plastic main material (3, 3', 3") is provided, said flag being connected to a back-injected part of the first film in a surface region (20c, 20c', 20c") of the body (1), which is spaced apart from an edge (31, 31') of the body limiting the surface (30) with the first film.

2. Body (1, 1', 1") according to claim 1, in which a shape of the body is predetermined by the plastic main material (3, 3', 3"), which shape allows the flag (F) to be brought at least partially into contact with the surface of the plastic main material on its side with the first film (2, 2', 2").

3. Body (1) according to claim 1 or 2, which has an even surface (30), on which the first film (2) is arranged, and wherein the flag (F) can be brought into a position or is located in a position in which it protrudes at an angle preferably from the range of from 15° to 90° to the plane from a surface region, to which the plastic main material attaches on all sides with respect to the surface.

4. Body (1, 1") according to claim 1 or 2, which has a curved surface (30'), on which the first film (2', 2") is arranged, and wherein the flag can be brought into a position or is located in a position in which it protrudes at an angle preferably from the range of from 75° to 0° to a surface normal of the curved surface on a surface region, to which the plastic main material is attached on all sides with respect to the surface.

5. Body according to one of the preceding claims, in which a transition (20c, 20c', 20c") takes place from a back-injected part of the first film (2, 2', 2") to a part of the film which is not back-injected along a line on the surface, which is preferably distanced (d, d') at least 2mm, preferably at least 3mm, particularly preferably at least 5mm, very particularly preferably at least 8mm away from an edge contour of the body limiting the surface with the first film (2, 2', 2").

6. Body according to one of the preceding claims, which has a second film (4) or a lacquer package, which is also back-injected with the plastic main material and has a full-surface or partial decorative layer, which preferably provides at least one piece of information with regard to the at least one electrical and/or electronic component.

7. Body according to one of the preceding claims, having a stiffening element, in particular having a thickness from the range of from 140 to 580µm and/or an additional contact element, in particular having a thickness from the range of from 1 to 15µm, on the flag.

8. Body according to one of the preceding claims, in which the functional layer (25) has a plurality of conducting paths, which consist of metal, in particular of silver, copper, aluminium, chromium or of a metal alloy, and which have a width of 100µm or more, or have a width of between 1µm and 40µm and are spaced apart from one another at a distance of between 10µm and 5mm and are preferably provided in a layer thickness of from 10 to 150nm, particularly preferably from 30 to 60nm.

9. Body according to one of claims 1 to 7, in which the functional layer comprises metal nanowires, in particular made of silver, copper, gold, metal nano particles, in particular made of silver, copper or gold, carbon nanotubes, carbon nano particles, graphene and/or organic conductors such as PEDOT/PSS and/or polyaniline, and/or provides active electric components, in particular organic light diodes, inorganic or organic photovoltaic cells, display elements provided using electroluminescent materials, electrochromic materials and/or electrophoretic materials, integrated circuits and/or inorganic or organic storage.

10. Body according to one of the preceding claims, in which the supporting substrate (21, 21', 21") consists of polyethylene terephthalate, polypropylene, polycarbonate, polyethylene naphthalate, and is preferably provided in a thickness of between 12 to 600µm, particularly preferably of between 35 to 60µm, wherein the substrate (21) is arranged between the functional layer (25) and the plastic main material (3), or wherein
the functional layer (25) is arranged between the substrate (21) and the plastic main material (3).

11. Body according to one of the preceding claims, having an adhesion promoting layer (22) at least on the part, which is back-injected with plastic, of the first film (2), which preferably consists of two partial layers which are formed from a different material.

12. Method for manufacturing a body (1), in particular a body (1) having the features according to one of claims 1 to 11, in which a first film (2) is inserted into an injection mould (9), wherein, in a first region (20a), the first film (2) has adhesion properties with respect to a predetermined injection moulding material (3), which are qualitatively better than the corresponding adhesion properties in a second region (20b) of the first film (2), wherein the second region (20b) has the shape of a tongue protruding from the first region, wherein, during the method, the predetermined injection moulding material (3) is injected into the injection mould with the first film, such that the first film (2) is partially back-injected and then the manufactured body (1) is removed, **characterised in that** the first film (2) is inserted into the injection mould (9) in such a way that, because of the properties of the first region (20a) and the second region (20b) of the first film (2) due to the different adhesion properties, injection moulding material (3) adheres to the first film (2) in the first region (20a), yet injection moulding material (3) poorly adheres or does not adhere to the first film (2) in the second region (20b).

13. Method according to claim 12, in which a film is inserted, which comprises an adhesion promoting layer (22) in the first region and/or comprises a layer (26) which suppresses the adhesion in the second region (20b).

14. Method for manufacturing a body having the features according to one of claims 1 to 11, in which a first film (2) is inserted into an injection mould (9), wherein, in the first region (20a), the first film (2) has adhesion properties with respect to a predetermined injection moulding material (3), which are qualitatively better than the corresponding adhesion properties in a second region (20b) of the first film (2), wherein the second region (20b) has the shape of a tongue protruding from the first region, and wherein, during the method, the second region (20b) is clamped between two clamping parts (9B, 93, 98a, 98b, 901, 902), and wherein injection moulding material (3) is injected into the injection mould (9) and thus the first region (20a) of the first film (2) is back-injected, wherein
a) the clamping elements comprise a mould half (9B) of the injection mould and either a separate slide (93) or a spring ejector (902) mounted in the mould half of the injection mould, or
b) the clamping elements comprise two clamping jaws (98a, 98b) which can be separated from each other by means of a folding core (99).

15. Method according to one of claims 12 to 14, in which a second film is introduced into the injection mould, which is also back-injected, and which comprises a carrier layer (41) and a transfer ply (42) and is supplied in a roll-to-roll process, wherein, after the back-injection, the transfer ply (42) at least partially adheres to the injection moulding material (3) and is detached from the carrier layer (41), and wherein the carrier layer (41) is guided away in the roll-to-roll process.

## Revendications

1. Corps (1, 1', 1''), qui présente une première feuille (2, 2', 2'') avec au moins une couche fonctionnelle électrique ou électronique (25) sur un substrat en plastique (21), dans lequel au moins un composant électrique et/ou électronique est mis à disposition dans une zone fonctionnelle (20a, 20a', 20a'') de la couche fonctionnelle, et dans lequel dans une zone de contact (20b, 20b', 20b'') de l'au moins une couche fonctionnelle (25) au moins un raccord électrique est prévu, lequel est couplé de manière galvanique avec au moins un composant, dans lequel le corps (1) comprend en outre un matériau principal en plastique (3, 3', 3''), dans lequel les propriétés d'adhérence entre la première feuille (2, 2', 2'') et le matériau principal en plastique (3, 3', 3'') dans une première zone se distinguent de celles dans une deuxième zone et la première feuille est partiellement moulée par injection à l'arrière avec le matériau principal en plastique (3, 3', 3'') de sorte que la zone de contact (20b, 20b', 20b'') est libre au moins en partie de matériau principal en plastique (3), dans lequel la première feuille (2, 2', 2'') est réalisée de sorte qu'un drapeau (F) séparé du matériau principal en plastique (3, 3', 3'') est mis à disposition par une partie non moulée par injection à l'arrière de la première feuille (2, 2', 2''), lequel se raccorde à une partie moulée par injection à l'arrière de la première feuille dans une zone de surface (20c, 20c', 20c'') du corps (1), qui est éloignée d'un bord (31, 31') du corps délimitant la surface (30) avec la première feuille.

2. Corps (1, 1', 1'') selon la revendication 1, dans lequel une forme du corps, qui permet d'amener le drapeau (F) au moins partiellement en appui contre la surface du matériau principal en plastique sur son côté avec la première feuille (2, 2', 2''), est prédéfinie par le matériau principal en plastique (3, 3', 3'').

3. Corps (1) selon la revendication 1 ou 2, lequel présente une surface plane (30), au niveau de laquelle la première feuille (2) est agencée, et dans lequel le drapeau (F) peut être amené dans une position ou se trouve dans une position, dans laquelle il fait saillie selon un angle de préférence de l'intervalle de 15° à 90° par rapport au plan d'une zone de surface, à laquelle se raccorde le matériau principal en plastique de toutes parts par rapport à la surface.

4. Corps (1, 1'') selon la revendication 1 ou 2, lequel présente une surface incurvée (30'), au niveau de laquelle la première feuille (2', 2'') est agencée, et dans lequel le drapeau peut être amené dans une position ou se trouve dans une position, dans laquelle il fait saillie selon un angle de préférence de l'intervalle de 75° à 0° par rapport à une normale à la surface de la surface incurvée au niveau d'une zone de surface, à laquelle se raccorde le matériau principal en plastique de toutes parts par rapport à la surface.

5. Corps selon l'une quelconque des revendications précédentes, dans lequel une transition (20c, 20c', 20c'') d'une partie moulée par injection à l'arrière de la première feuille (2, 2', 2'') à une partie non moulée par injection à l'arrière de la feuille a lieu le long d'une ligne sur la surface, qui est éloignée (d, d') au moins de 2 mm, de préférence au moins de 3 mm, de manière particulièrement préférée au moins de 5 mm, de manière tout particulièrement préférée au moins de 8 mm d'un contour de bord du corps délimitant la surface avec la première feuille (2, 2', 2'').

6. Corps selon l'une quelconque des revendications précédentes, qui présente une deuxième feuille (4) ou un paquet de vernis, qui est moulé ou moulée également par injection à l'arrière avec le matériau principal en plastique et présente une couche décorative de pleine surface ou partielle, laquelle met à disposition de préférence au moins une information relative à l'au moins un composant électrique et/ou électronique.

7. Corps selon l'une quelconque des revendications précédentes, avec un élément de rigidification, en particulier d'une épaisseur de l'intervalle de 140 à 580 µm, et/ou un élément de contact supplémentaire, en particulier d'une épaisseur de l'intervalle de 1 à 15 µm, au niveau du drapeau.

8. Corps selon l'une quelconque des revendications précédentes, dans lequel la couche fonctionnelle (25) présente une pluralité de pistes conductrices, qui se composent de métal, en particulier d'argent, de cuivre, d'aluminium, de chrome, ou d'un alliage métallique, et qui présentent une largeur de 100 µm ou plus, ou présentent une largeur entre 1 µm et 40 µm et ont une distance entre 10 µm et 5 mm l'une par rapport à l'autre et sont mises à disposition de préférence dans une épaisseur de couche de 10 à 150 nm, de manière particulièrement préférée de 30 à 60 nm.

9. Corps selon l'une quelconque des revendications 1 à 7, dans lequel la couche fonctionnelle comprend des nanofils métalliques, en particulier en argent, cuivre, or, des nanoparticules métalliques, en particulier en argent, cuivre ou or, des nanotubes de carbone, des nanoparticules de carbone, du graphène, et/ou des conducteurs organiques tels que PEDOT/PSS et/ou de la polyaniline et/ou met à disposition des composants électriques actifs, en particulier des diodes électroluminescentes organiques, des cellules photovoltaïques anorganiques ou organiques, des éléments d'affichage mis à disposition en utilisant des matériaux électroluminescents, des matériaux électrochromes et/ou des matériaux électrophorétiques, des commutations intégrées et/ou des accumulateurs anorganiques ou organiques.

10. Corps selon l'une quelconque des revendications précédentes, dans lequel le substrat porteur (21, 21', 21'') se compose de polytéréphtalate d'éthylène, de polypropylène, de polycarbonate, de polynaphtalate d'éthylène et est mis à disposition de préférence dans une épaisseur entre 12 à 600 µm de manière particulièrement préférée entre 35 à 60 µm, dans lequel le substrat (21) est agencé entre la couche fonctionnelle (25) et le matériau principal en plastique (3), ou dans lequel
la couche fonctionnelle (25) est agencée entre le substrat (21) et le matériau principal en plastique (3).

11. Corps selon l'une quelconque des revendications précédentes, avec une couche d'adhésif (22) au moins au niveau de la partie moulée par injection à l'arrière avec du plastique de la première feuille (2), laquelle se compose de préférence de deux couches partielles, lesquelles sont formées de différent matériau.

12. Procédé de fabrication d'un corps (1), en particulier d'un corps (1) avec les caractéristiques selon l'une quelconque des revendications 1 à 11, dans lequel une première feuille (2) est insérée dans un moule de moulage par injection (9), dans lequel la première feuille (2) présente dans une première zone (20a) des propriétés d'adhérence par rapport à un matériau de moulage par injection prédéterminé (3), qui sont meilleures du point de vue qualitatif que les propriétés d'adhérence correspondantes dans une deuxième zone (20b) de la première feuille (2), dans lequel la deuxième zone (20b) présente la forme d'une languette éloignée de la première zone, dans lequel lors du procédé le matériau de moulage par injection prédéterminé (3) est injecté dans le moule de moulage par injection avec la première feuille, de sorte que la première feuille (2) est partiellement moulée par injection à l'arrière et ensuite le corps fabriqué (1) est prélevé, **caractérisé en ce que** la première feuille (2) est insérée dans le moule de moulage par injection (9) de sorte qu'en raison des propriétés de la première zone (20a) et de la deuxième zone (20b) de la première feuille (2) en raison des différentes propriétés d'adhérence le matériau de moulage par injection (3) adhère à la première feuille (2) dans la première zone (20a), mais le matériau de moulage par injection (3) n'adhère pas ou mal à la première feuille (2) dans la deuxième zone (20b).

13. Procédé selon la revendication 12, dans lequel une feuille est insérée, qui comprend une couche d'adhésif (22) dans la première zone et/ou comprend une couche inhibant l'adhérence (26) dans la deuxième zone (20b).

14. Procédé de fabrication d'un corps avec les caractéristiques selon l'une quelconque des revendications 1 à 11, dans lequel une première feuille (2) est insérée dans un moule de moulage par injection (9), dans lequel la première feuille (2) présente dans une première zone (20a) des propriétés d'adhérence par rapport à un matériau de moulage par injection prédéterminé (3), qui sont meilleures du point de vue qualitatif que les propriétés d'adhérence correspondantes dans une deuxième zone (20b) de la première feuille (2), dans lequel la deuxième zone (20b) présente la forme d'une languette éloignée de la première zone, et dans lequel lors du procédé la deuxième zone (20b) est coincée entre deux parties de serrage (9B, 93, 98a, 98b, 901, 902), et dans lequel le matériau de moulage par injection (3) est injecté dans le moule de moulage par injection (9) et ainsi la première zone (20a) de la première feuille (2) est moulée par injection à l'arrière, dans lequel
a) les éléments de serrage comprennent un demi-moule (9B) du moule de moulage par injection et soit un coulisseau séparé (93) soit un éjecteur ressort (902) logé dans le demi-moule du moule de moulage par injection ou
b) les éléments de serrage comprennent deux mâchoires de serrage (98a, 98b) séparable l'une de l'autre par un noyau de pliage (99).

15. Procédé selon l'une quelconque des revendications 12 à 14, dans lequel une deuxième feuille est introduite dans le moule de moulage par injection, qui est également moulée par injection à l'arrière et qui comprend une couche de support (41) et une couche de transfert (42) et est amenée dans un procédé rouleau à rouleau, dans lequel après le moulage par injection à l'arrière, la couche de transfert (42) adhère au moins partiellement au matériau de moulage par injection (3) et est détachée de la couche de support (41) et dans lequel la couche de support (41) est évacuée dans le procédé rouleau à rouleau.
